# EUROPÄISCHE PATENTANMELDUNG

(11) **EP 4 782 846 A1**
(43) Veröffentlichungstag der Anmeldung: **29.07.2026**
(21) Anmeldenummer: 26151234.7
(22) Anmeldetag: 12.01.2026
(51) Int. Cl.: G01R 1/067, G01R 31/52, G01R 27/20, G01R 31/08, G01R 31/58, G01V 3/02

(54) **VORRICHTUNG FÜR EIN MESSSYSTEM ZUR VERBESSERUNG DER ELEKTRISCHEN LEITFÄHIGKEIT**

(30) Priorität: 23.01.2025 DE 102025102482
(71) Anmelder: Westnetz GmbH, 44139 Dortmund (DE)
(72) Erfinder: Deutsch, Johannes, 54295 Trier (DE)
(74) Vertreter: Bals & Vogel Patentanwälte PartGmbB

(57) **Zusammenfassung**

Die Erfindung betrifft eine Vorrichtung (100) für ein Messsystem (1000), insbesondere umfassend eine Erdschlusssonde, die Vorrichtung (100) aufweisend:
einen Griff (10), welcher eingerichtet ist, von einem Benutzer bedient zu werden, um die Vorrichtung (100) zu bewegen,
ein Unterteil (20), das mit dem Griff (10) verbunden ist und, insbesondere relativ zu einer Vertikalen (z), unterhalb von dem Griff (10) angeordnet ist, das Unterteil (20) aufweisend:
eine Elektrode (60), welche in einem unteren Abschnitt des Unterteils (20) angeordnet ist, eine Benetzungseinheit (30), welche zumindest abschnittsweise oberhalb der Elektrode (60) angeordnet ist, wobei die Benetzungseinheit (30) dazu eingerichtet ist, ein leitfähiges Medium an die Elektrode (60) bereitzustellen.
Weiterhin betrifft die Erfindung ein Messsystem (1000).

## Beschreibung

Die Erfindung betrifft eine Vorrichtung sowie ein Messsystem.

Bekannt sind Messsysteme zum Detektieren eines Erdschlusses. Dabei kann in der Erde und/oder (unterhalb von einem) Untergrund eine elektrische Leitung verlegt sein. Wenn diese gewartet oder untersucht wird, insbesondere wenn ein Defekt, etwa ein Erdschluss (also eine elektrisch leitfähige Beschädigung zur Erde bzw. zu Masse) vorliegt, kann durch ein derartiges Messsystem die Position des Defektes bzw. Erdschlusses ermittelt werden. Dies kann durch eine (ausschließliche) Messung (z. B. über eine Gleichtaktspannung) an und/oder oberhalb des Untergrunds erfolgen. Dadurch kann ein (vollständiges) Freilegen der vergrabenen Leitung verhindert werden. Dabei umfassen diese Messsysteme beispielsweise eine oder zwei Vorrichtungen, etwa Erdspieße, welche als Pole und/oder Kontakte fungieren, um eine oder mehrere Potentialmessung(en) durchzuführen, insbesondere entlang und/oder oberhalb einer im Untergrund verlaufenden elektrischen Leitung. Hierbei kann beispielsweise die sogenannte Schrittspannungsmethode angewandt werden, wobei mehrere Potentialmessungen über die Vorrichtung(en) nacheinander an unterschiedlichen Positionen entlang der und/oder oberhalb der Leitung durchgeführt werden. Beispielsweise kann die Position eines Erdschlusses anhand eines Polaritätswechsels des Signal- bzw. Spannungsverlaufs erkannt werden. Die Vorrichtung(en) können dabei mit einer Steuereinheit, etwa einer Erdschlusssonde, elektrisch und/oder datenkommunizierend verbunden sein. Die Vorrichtung(en) können als Erdspieße und/oder als Stangen ausgebildet sein.

Der Stand der Technik weist Nachteile auf. So kann es sein, dass elektrische Leitungen unterhalb von versiegeltem Untergrund verlaufen, beispielsweise unterhalb einer (asphaltierten) Straße. Somit muss ein Benutzer des Messsystems und/oder der Vorrichtung diese aktiv festhalten, um insbesondere ein Umfallen zu verhindern. Dies kann die Sicherheit, die Geschwindigkeit (beim Durchführen mehrerer Messungen), die Effizienz, die Genauigkeit und/oder den Komfort reduzieren. Zudem kann ein Transport unvorteilhaft sein, da die Vorrichtung(en) am Boden abgelegt werden und/oder anderweitig angelehnt werden. Selbst bei einem Festhalten (beim Durchführen der Messungen) kann es zu Veränderungen (z. B. durch Unachtsamkeit und/oder Wackeln) kommen. Dadurch kann sich der Übergangswiderstand zwischen Untergrund und Vorrichtung ändern. Dies kann die Messung verfälschen, und damit insbesondere die (Genauigkeit und/oder Zuverlässigkeit) der Lokalisierung eines Erdschlusses. Es kann weiterhin notwendig sein, dass zusätzliche Benutzer bzw. Helfer notwendig sind. Dies kann die Kosten und/oder den Aufwand erhöhen. Es kann (unabhängig vom Untergrund) sein, dass dieser keine (ausreichende) elektrische Leitfähigkeit aufweist. Beispielsweise kann dies auf das Material und/oder (mangelnde) Feuchtigkeit des Untergrunds zurückzuführen sein. Eine Möglichkeit kann eine (aktive) Bewässerung (etwa durch eine Gießkanne) darstellen, was aber insbesondere weiteren Aufwand und/oder weitere Benutzer bzw. Helfer erfordert.

Es ist daher eine Aufgabe der vorliegenden Erfindung, wenigstens einen der voranstehend beschriebenen Nachteile zumindest teilweise zu überwinden. Insbesondere ist es Aufgabe der Erfindung Komfort, Geschwindigkeit, Robustheit, Genauigkeit, Flexibilität, Kosten, Transportfähigkeit und/oder Sicherheit zu optimieren.

Die voranstehende Aufgabe wird gelöst durch eine Vorrichtung gemäß einem ersten Aspekt der vorliegenden Erfindung sowie durch ein Messsystem gemäß einem zweiten Aspekt der vorliegenden Erfindung. Weitere Merkmale und Details der Erfindung ergeben sich aus den Unteransprüchen, der Beschreibung und den Zeichnungen. Dabei gelten Merkmale und Details, die im Zusammenhang mit der erfindungsgemäßen Vorrichtung beschrieben sind, selbstverständlich auch im Zusammenhang mit dem erfindungsgemäßen Messsystem und jeweils umgekehrt, sodass bezüglich der Offenbarung zu den einzelnen Erfindungsaspekten stets wechselseitig Bezug genommen wird bzw. werden kann.

Gemäß einem ersten Aspekt betrifft die vorliegende Erfindung eine Vorrichtung für ein (elektrisches) Messsystem, (das Messsystem) insbesondere umfassend eine Steuereinheit, vorzugsweise eine Erdschlusssonde, und/oder eine (oder zwei) Vorrichtung(en), die Vorrichtung(en) aufweisend:
- einen Griff, welcher eingerichtet ist von einem Benutzer bedient zu werden, um die Vorrichtung zu bewegen,
- ein Unterteil, das mit dem Griff verbunden ist und, insbesondere relativ zu (entgegen) einer Vertikalen, unterhalb von dem Griff angeordnet ist, das Unterteil aufweisend:
   ∘ eine Elektrode, welche in einem unteren Abschnitt des Unterteils angeordnet ist,
   ∘ eine Benetzungseinheit, welche zumindest abschnittsweise oberhalb der Elektrode angeordnet ist, wobei die Benetzungseinheit dazu eingerichtet ist ein (elektrisch) leitfähiges Medium an die Elektrode bereitzustellen.

Ein Messsystem kann eine Steuereinheit, insbesondere eine Erdschlusssonde, aufweisen. Die Steuereinheit, insbesondere Erdschlusssonde, kann elektrisch und/oder datenkommunizierend mit der Elektrode verbindbar sein, insbesondere in einer Betriebsstellung mit der Elektrode elektrisch verbunden sein, um eine Messspannung und/oder einen Messstrom an diese bereitzustellen, bzw. zu erfassen (siehe auch unten). Das Messsystem kann zumindest eine, vorzugsweise zwei (oder mehr), Vorrichtungen aufweisen. Dabei kann eine bzw. können mehrere Messungen von Spannung und/oder Potentialen zwischen den Vorrichtungen durchgeführt werden, wobei insbesondere die Vorrichtungen voneinander beabstandet auf einem (darunter befindlichen) Untergrund positioniert sein können. Dadurch kann (anhand des Potentialverlaufs in Abhängigkeit von den Messpositionen) ein Erdschluss detektiert werden. Demnach können das Messsystem, die Steuereinheit und/oder die Vorrichtung dazu eingerichtet sein, (gemeinsam) einen Erdschluss zu detektieren (bzw. dies zu unterstützen, etwa durch Bereitstellung eines Pols bzw. eines Kontakts durch eine Elektrode).

Der Griff, welcher eingerichtet ist (um) von einem Benutzer bedient/ergriffen zu werden, um die Vorrichtung zu bewegen, kann dabei als Handgriff ausgeführt sein. Vorzugsweise kann der Griff in einem oberen Abschnitt und/oder an einem oberen Ende der Vorrichtung angeordnet sein. Der Benutzer kann den Griff (mit der Hand) greifen, und (dadurch) insbesondere die (gesamte) Vorrichtung bewegen, beispielsweise entlang einer Vertikalen (welche senkrecht ist zu einem darunter befindlichen Untergrund bzw. der Erdoberfläche). Auch kann der Benutzer die Vorrichtung mithilfe des Griffs senkrecht zu der Vertikalen bewegen und/oder transportieren, um vorteilhafterweise dadurch (einfach) die Vorrichtung an eine (neue bzw. weitere) Messposition zu bringen. Durch den Griff kann vorteilhafterweise eine einfache Handhabung ermöglicht und/oder der Komfort verbessert werden. Der Griff kann sich beispielsweise (etwa) in Höhe eines Ellbogens eines Benutzers befinden, wenn die Vorrichtung (in der Betriebsstellung) auf dem Untergrund steht. Dies kann ein besonders einfaches Handhaben ermöglichen. Vorzugsweise kann der Griff und/oder das Unterteil einen Isolationsabschnitt aufweisen. Die Vorrichtung und/oder der Griff kann ein Verbindungsteil aufweisen, welches den Griff mit dem Unterteil verbindet. Dabei kann das Verbindungsteil (zumindest abschnittsweise) elektrisch isolierend ausgestaltet sein. Somit kann der Griff von dem Unterteil, insbesondere der Elektrode, elektrisch isoliert sein. Dadurch kann vorteilhafterweise eine Beeinflussung der Messung durch den Benutzer (oder umgekehrt) verhindert werden. Dies kann auch die Sicherheit erhöhen. Es kann auch vorgesehen sein, dass der Griff und/oder das Verbindungsteil fluchtend ausgestaltet sind, beispielsweise stangenförmig. Das Verbindungsteil kann mit der Benetzungseinheit (mechanisch) verbunden sein, beispielsweise an dieser verschraubt. Es kann auch vorgesehen sein, dass das Verbindungsteil durchgehend ausgestaltet ist und/oder (symmetrisch und/oder mittig) durch die Benetzungseinheit geführt ist, und insbesondere danach endet und/oder mit (einem oberen Ende) der Entkopplungseinheit verbunden ist.

Alternativ oder zusätzlich kann es vorgesehen sein, dass der Griff eine Trägerstruktur aufweist, welche dazu eingerichtet ist zumindest eine, zwei und/oder genau zwei Vorrichtungen aufzunehmen und/oder zu tragen. Beispielsweise kann die Trägerstruktur mit zwei Enden ausgebildet sein, beispielsweise konstruiert aus Aluminiumprofilen und/oder als ein sog. "A-Frame" und/oder (im Schnitt) A-förmig ausgebildet sein, wobei insbesondere an einem oder beiden unteren Enden (des "A") zumindest eine Elektrode angeordnet ist. Demnach kann jedes untere Ende (analog zu oben bzw. unten) entsprechend eine identische und/oder baugleiche Vorrichtung aufweisen. Vorzugsweise kann es dabei vorgesehen sein, dass sich die Vorrichtungen einen Vorratstank und/oder eine Freigabeeinheit teilen. Es kann vorgesehen sein, dass dabei jede Vorrichtung eine (eigene) Entkopplungseinheit aufweist.

Die Vorrichtung kann (im einfachsten Fall und/oder während eines Messens) entlang und/oder fluchtend mit einer Vertikalen angeordnet sein. Dabei kann eine Vertikale vom Untergrund (Erdmittelpunkt) aus (senkrecht) nach oben weisend ausgebildet sein. So kann der Benutzer beispielsweise (über den Griff) die Vorrichtung nach oben (entlang der Vertikalen) anheben, insbesondere um von einer Betriebsstellung in eine Transportstellung zu wechseln. So kann der Benutzer beispielsweise (über den Griff) die Vorrichtung nach unten (entgegen der Vertikalen) absetzen, insbesondere um von einer Transportstellung in eine Betriebsstellung zu wechseln. Die Vorrichtung kann (insgesamt) länglich und/oder stabförmig ausgestaltet sein. Dies kann vorteilhafterweise den Transport und/oder die Lagerung optimieren. Durch die Anordnung bzw. Reihenfolge der Bestandteile/Bauteile der Vorrichtung (entlang der Vertikalen), kann vorteilhafterweise die Standfestigkeit optimiert werden. Vorzugsweise umfasst die Vorrichtung einen bezüglich (entgegen) der Vertikalen tiefliegenden und/oder nahe des Untergrunds befindlichen Schwerpunkt. Dies kann vorteilhafterweise die (mechanische und/oder elektrische) Robustheit und/oder Sicherheit optimieren. Dadurch kann die Effizienz und/oder Genauigkeit (beim Messen und/oder Positionieren) optimiert werden. Ein niedriger Schwerpunkt kann dabei durch ein (vergleichsweise) hohes Gewicht (und/oder hohe Dichte) der Elektrode, Kontakteinheit und/oder Erdspieß(e) realisiert werden. Alternativ oder zusätzlich kann dies durch eine bezüglich (entgegen) der Vertikalen tiefliegende und/oder nahe des Untergrunds befindliche Benetzungseinheit optimiert werden.

Das Unterteil, das (mechanisch und/oder zumindest abschnittweise elektrisch isolierend) mit dem Griff verbunden ist und, insbesondere relativ zu (entgegen) der Vertikalen, unterhalb von dem Griff angeordnet ist, kann demnach einen unteren Teil der Vorrichtung bilden. Es kann vorgesehen sein, dass der Griff reversibel lösbar an dem Unterteil befestigt ist, etwa über einen Bajonettverschluss. Dadurch kann der Griff getauscht werden. Dadurch kann auch die Gesamtlänge (entlang der Vertikalen) verringert werden (etwa zur Lagerung oder zum Transport). Zudem kann hierdurch die Ergonomie verschiedener Benutzer (je nach ihrer jeweiligen Körpergröße berücksichtigt werden. Denkbar ist zudem auch eine Art Teleskopverstellung (entweder mit fest / vordefinierten Einrastpunkten) oder eine stufenlsose, sich klemmende Verstellung. Im Rahmen der Erfindung können sich Positionsangaben auf die Vertikale beziehen, sofern nicht anders beschrieben. Das Unterteil, insbesondere die Elektrode, kann vorzugsweise vor dem Durchführen einer Messung (auf dem Untergrund und/oder durch Handhabung des Griffes) positioniert werden. Beim Messen und/oder in einer Betriebsstellung kann das Unterteil, insbesondere das unterste Ende des Unterteils und/oder der Elektrode, vorzugsweise flächig, auf dem Untergrund aufliegen.

Die Elektrode, welche in einem unteren Abschnitt des Unterteils angeordnet ist, kann als (elektrischer) Sensor, Detektor, Kontakt, Pol und/oder Anschluss ausgestaltet sein und/oder funktionieren. Die Elektrode ist elektrisch leitend ausgestaltet. Beispielsweise kann die Elektrode ein Metall aufweisen, vorzugsweise Aluminium, (Edel-)Stahl, Kupfer, Messing, Silber und/oder Gold. Es kann vorgesehen sein, dass die Elektrode, insbesondere an der Unterseite, eine leitfähige Beschichtung aufweist, insbesondere mit (besonders) hoher Leitfähigkeit, beispielsweise Kupfer, Silber und/oder Gold. Dadurch kann die (elektrische) Kontaktierung und/oder der Übergangswiderstand (weiter) optimiert werden. Es kann vorgesehen sein, dass die Elektrode, insbesondere an der Unterseite, Fäden aufweist, beispielsweise Metallfäden. Dies können die (elektrische) Kontaktierung und/oder der Übergangswiderstand (noch weiter) optimieren, beispielsweise indem diese Unebenheiten und/oder Rillen in dem Untergrund zumindest teilweise ausfüllen. Die Elektrode kann zumindest teilweise durchlässig sein für das Medium. Dadurch kann das Medium an der Oberfläche, außen von der, durch die und/oder über die Elektrode abgegeben (bzw. geführt) werden, vorzugsweise an den (zumindest in der Betriebsstellung) darunter befindlichen Untergrund. Dadurch kann das Medium den Untergrund (zumindest teilweise) benetzen und/oder in diesen (zumindest teilweise) eindringen, insbesondere in und/oder durch Unebenheiten, Risse und/oder Rillen.

Vorzugsweise ist das Unterteil, die Elektrode, und/oder die Kontakteinheit, insbesondere am untersten Ende, flach, eben, plattenartig und/oder planar ausgebildet. Dies kann vorteilhafterweise die Standfestigkeit, die Sicherheit, das Positionieren und/oder die (Mess-)Genauigkeit optimieren. Dadurch kann zur Bedienung ein Benutzer ausreichend sein und/oder auf weitere (Hilfe) verzichtet werden. Dadurch kann auch ein Wackeln und/oder Verändern des Übergangswiderstands (zwischen Elektrode und Untergrund) verhindert und/oder minimiert werden. Dies kann zu einer Zeitersparnis und/oder verringerten Kosten und/oder höherer Messgenauigkeit führen.

Die Benetzungseinheit, welche zumindest abschnittsweise (vorzugsweise vollständig) oberhalb der Elektrode angeordnet ist, ist dazu eingerichtet ein (elektrisch) leitfähiges Medium an die Elektrode bereitzustellen. Das Medium ist vorzugsweise für eine Erhöhung der Leitfähigkeit (des Untergrunds) und/oder einer Reduzierung des Übergangswiderstands (zwischen Vorrichtung und Untergrund) eingerichtet. Dabei kann das Medium im einfachsten Fall Wasser aufweisen. Das Medium kann (zusätzlich) Salz aufweisen, wodurch vorteilhafterweise die Leitfähigkeit erhöht werden kann und/oder ein Gefrieren reduziert bzw. verhindert werden kann. Die Benetzungseinheit kann (zumindest teilweise) zum Speichern und/oder Aufbewahren des Mediums eingerichtet sein, und insbesondere als (abgedichteter) Tank ausgestaltet sein (siehe unten). Die Benetzungseinheit, insbesondere die Freigabeeinheit, kann zur Bereitstellung des Mediums an die Elektrode mit dieser mediumführend und/oder fluidführend und/oder wasserführend verbunden sein, beispielsweise über ein Rohr (bzw. Rohre) und/oder einen Schlauch (bzw. Schläuche). Die Benetzungseinheit, insbesondere der Vorratstank und/oder die Freigabeeinheit, kann einen (reversibel verschließbaren) Füllstutzen aufweisen, über welchen das Medium (von außen, etwa über einen Wasserhahn, eine Flasche, einen Kanister, eine Gießkanne, o.Ä.) eingefüllt werden kann. Die Benetzungseinheit, insbesondere die Freigabeeinheit, kann dazu eingerichtet sein, das Medium wahlweise und/oder steuerbar und/oder automatisiert an die Elektrode bereitzustellen, insbesondere über ein Ventil (siehe unten). Dadurch kann vorteilhafterweise (nur) eine Bereitstellung von dem Medium erfolgen, wenn die Vorrichtung, insbesondere das Unterteil und/oder die Elektrode, auf dem Untergrund abgestellt wird (eben an einer vom Benutzer bestimmten Messposition) und/oder sich in der Betriebsstellung befindet. Dadurch kann vorteilhafterweise eine Bereitstellung von dem Medium verhindert werden, wenn die Vorrichtung, insbesondere das Unterteil und/oder die Elektrode, nicht auf dem Untergrund abgestellt wird und/oder transportiert wird bzw. hochgehoben ist und/oder sich in der Transportstellung befindet. Dadurch kann Medium eingespart werden, was die Kosten, Effizienz und/oder den Komfort erhöht. Weiter kann hierdurch die Nutzungsdauer erhöht werden, da weniger häufig Medium in der Vorrichtung auf- / nachgefüllt werden muss. Dadurch kann zudem eine Gefährdung, insbesondere beim Transportieren bzw. in einer Transportstellung durch unerwünscht austretendes Medium (Nässe/Glätte) verhindert werden. Dadurch kann die Sicherheit verbessert werden.

Im Rahmen der Erfindung kann es von Vorteil sein, dass die Benetzungseinheit dazu eingerichtet ist, das Medium, insbesondere eine leitfähige Flüssigkeit, beispielsweise (salzhaltiges) Wasser, an die Elektrode bereitzustellen und/oder dieser zuzuführen, wobei über die Elektrode (bzw. die Elektrode eingerichtet ist), insbesondere über und/oder durch zumindest eine Durchführung (oder mehrere Durchführungen), vorzugsweise eine Bohrung (oder mehrere Bohrungen), das Medium an einen unterhalb der Elektrode anordenbaren und/oder in der Betriebsstellung angeordneten Untergrund abgebbar ist und/oder abgegeben wird (bzw. abzugeben).

Dabei kann die Durchführung und/oder die Durchführungen kanalartig und/oder als Bohrung ausgestaltet sein. Die Elektrode und/oder die Durchführung(en) können dazu eingerichtet sein, das Medium von der Benetzungseinheit und/oder einer Oberseite der Elektrode, durch die Elektrode, zu einer Unterseite der Elektrode zu führen, und insbesondere dadurch an und/oder auf den Untergrund abzugeben. Die Durchführung(en) können beispielsweise (zumindest abschnittsweise) parallel zur Vertikalen ausgestaltet sein. Eine einzelne Durchführung kann dabei vorteilhaft sein, um das gesamte Medium punktuell abzugeben. Dadurch kann dieses schneller und/oder tiefer an und/oder in den Untergrund gelangen. Dies kann die Messung (potentiell) verbessern. Mehrere (insbesondere voneinander beabstandete) Durchführungen können dabei vorteilhaft sein, das Medium (voll)flächig im Bereich der Unterseite der Elektrode zu verteilen. Dadurch kann sich der Übergangswiderstand weiter reduzieren, was die Genauigkeit erhöhen kann, und die Messung (potentiell) verbessern kann. Es kann auch vorgesehen sein, dass eine Durchführung, insbesondere ein Einlass der Elektrode bzw. der Durchführung vorgesehen ist, welcher mit der Benetzungseinheit, insbesondere der Freigabeeinheit und/oder der Verbindungsleitung der Freigabeeinheit (siehe unten) verbunden ist. Ausgehend von der Durchführung und/oder dem Einlass der Elektrode bzw. der Durchführung kann sich diese kanalartig und/oder netzartig verzweigen. Dadurch kann vorteilhafterweise eine verbesserte Verteilung des Mediums (senkrecht zur Vertikalen) ermöglicht werden. Alternativ kann es vorgesehen sein, dass die Elektrode und/oder die Durchführung (obenliegend) eine Kammer aufweist, in welcher das Medium eingespeist werden kann, wobei ausgehend von der Kammer (symmetrisch und/oder im gleichen Abstand von einem Einlass angeordnete) Kanäle (entgegen der Vertikalen) nach unten weisend ausgebildet sind. Dadurch kann die Abgabe des Mediums bereits bei der Konstruktion und/oder durch Wahl einer Elektrode beeinflusst werden. Es kann vorgesehen sein, dass die Elektrode austauschbar ausgebildet ist. Beispielsweise kann diese unterhalb der Benetzungseinheit und/oder Entkopplungseinheit, beispielsweise an einem Rohr und/oder einer Stange, reversibel lösbar angeordnet sein, vorzugsweise durch ein Innengewinde und/oder Außengewinde. Demnach können Elektroden mit unterschiedlichen Durchführungen verwendet werden, wobei diese vorzugsweise (durch identische Position eines jeweiligen Einlasses) allesamt mit der Vorrichtung und/oder der Benetzungseinheit kompatibel sind. Dies kann vorteilhafterweise die Flexibilität und/oder Effizienz erhöhen. Es kann vorgesehen sein, dass, insbesondere an einer Unterseite und/oder einem (Innen-)Gewinde der Elektrode, die Durchführung(en) mittig oder nahe der Mitte einen Auslass aufweisen. Es kann vorgesehen sein, dass, insbesondere an einer Unterseite und/oder einem (Innen-)Gewinde der Elektrode, die Durchführung(en) und/oder nahe und/oder an und/oder in dem (Innen-)Gewinde der Elektrode einen Auslass aufweisen. Dies kann vorteilhaft sein, um ein Austreten des Mediums mittig und/oder nahe des (Innen-)Gewindes bereitzustellen, was insbesondere vorteilhaft sein kann, wenn eine Messerweiterung, etwa ein Erdspieß, an der Vorrichtung und/oder (Unterseite der) Elektrode angeordnet ist (siehe unten). Dabei kann vorteilhafterweise das Medium nahe des Erdspießes und/oder entlang des Erdspießes (z. B. entgegen der Vertikalen) an und/oder (tief[er]) in den Untergrund gelangen.

Im Rahmen der Erfindung ist es denkbar, dass die Elektrode, insbesondere eine (nach unten und/oder entgegen der Vertikalen weisende) Unterseite der Elektrode, flach und/oder plattenförmig ausgestaltet ist.

Vorzugsweise ist das Unterteil, die Elektrode, die Beschichtung, die Unterseite der Elektrode und/oder die Kontakteinheit, insbesondere am untersten Ende, flach, eben, scheibenförmig, plattenartig und/oder planar ausgebildet. Dies kann vorteilhafterweise die Standfestigkeit (insbesondere ohne aktives Halten durch den Benutzer), die Sicherheit, das Positionieren und/oder die (Mess-)Genauigkeit optimieren. Dies kann (auch) eine einfache Fertigung ermöglichen. Zudem kann die Vorrichtung (einfach) stehen gelassen werden, wodurch der Benutzer andere Tätigkeiten, z. B. das Umpositionieren einer anderen (baugleichen) Vorrichtung durchführen kann. Der Übergangswiderstand kann dabei vorteilhafterweise konstant gehalten werden.

Vorzugsweise weist das Unterteil, die Elektrode, die Beschichtung, die Unterseite der Elektrode und/oder die Kontakteinheit, insbesondere am untersten Ende, ein (vergleichsweise) hohes Gewicht und/oder eine hohe Dichte auf. Dies kann vorteilhafterweise (zusätzlich zu einer flachen Ausgestaltung, siehe oben) die Standfestigkeit, die Sicherheit, das Positionieren und/oder die (Mess-)Genauigkeit optimieren. Dies kann (auch) realisiert werden, durch einen tiefen Schwerpunkt. Dabei kann beispielsweise die Elektrode ein (vergleichsweise und/oder [absichtlich] schweres) Metall, etwa Edelstahl, Blei, Silber, Gold und/oder Platin aufweisen. Dabei kann beispielsweise der Griff, die Benetzungseinheit und/oder das Verbindungsteil ein (vergleichsweise und/oder [absichtlich] leichtes) Material aufweisen, beispielsweise Kunststoff, Aluminium und/oder Carbon.

Es kann im Rahmen der Erfindung vorgesehen sein, dass die Elektrode, insbesondere an der Unterseite, eine Kontakteinheit aufweist, welche dazu eingerichtet ist, das Medium zumindest teilweise zu verteilen, und/oder insbesondere (zeitweise und/oder abschnittsweise) zu speichern, wobei die Kontakteinheit an der Elektrode reversibel lösbar anordenbar und/oder befestigt ist, insbesondere über ein (in einer [zentrischen und/oder nach unten weisenden] Bohrung befindliches) Innengewinde der Elektrode, welches mit einem (obenliegenden und/oder nach oben [entlang der Vertikalen] weisenden) Außengewinde der Kontakteinheit (reversibel lösbar und/oder werkzeuglos) in Eingriff gebracht werden kann.

Durch die Kontakteinheit kann das Medium (besser) verteilt und/oder (teilweise) gespeichert werden, wodurch vorteilhafterweise eine konstantere und/oder verzögerte Bereitstellung an den Untergrund erfolgen kann. Dadurch kann eine (rasche) Ausbreitung des Mediums auf dem Untergrund und/oder senkrecht zu der Vertikalen verringert und/oder verhindert werden, wobei insbesondere stattdessen das Medium (tendenziell besser) in den Untergrund eindringen kann. Dies kann beispielsweise bei einem Untergrund wie Schotter, gepflasterten Flächen, einer beschädigten oder porösen Straße, Gehweg(platten) und/oder Rasengittersteinen vorteilhaft sein. Weiterhin kann die Verteilung durch die Struktur und/oder das Material der Kontakteinheit beeinflusst und/oder verbessert werden. Die Kontakteinheit kann beispielsweise (zumindest teilweise) flexibel und/oder komprimierbar sein. Beispielsweise kann die Kontakteinheit (zumindest abschnittsweise) als Schwamm und/oder schwammartig ausgebildet sein. Dies kann beispielsweise ein Nachtropfen verhindern, wenn die Vorrichtung vom Untergrund gelöst wird, insbesondere da in einer Betriebsposition die Kontakteinheit (tendenziell) komprimiert und/oder leer (wenig Medium enthaltend) ausgebildet ist und in einer Transportstellung von der Elektrode abgegebenes Medium aufsaugen und/oder speichern kann (da die Kontakteinheit dann dekomprimiert und/oder saugfähig ausgebildet ist). Die Kontakteinheit kann (zumindest teilweise) elektrisch leitend ausgestaltet sein. Beispielsweise kann die Kontakteinheit ein Metall aufweisen, vorzugsweise (Edel-)Stahl, Kupfer, Silber und/oder Gold. Dadurch kann die (elektrische) Kontaktierung und/oder der Übergangswiderstand (weiter) optimiert werden. Es kann vorgesehen sein, dass die Kontakteinheit, insbesondere an der Unterseite, Fäden aufweist, beispielsweise Metallfäden. Dies können die (elektrische) Kontaktierung und/oder der Übergangswiderstand (noch weiter) optimieren, beispielsweise indem diese Unebenheiten und/oder Rillen in dem Untergrund zumindest teilweise ausfüllen. Die Kontakteinheit kann zumindest teilweise durchlässig sein für das Medium. Dadurch kann Medium an der (Oberfläche der), außen von der, durch die und/oder über die Kontakteinheit abgegeben (bzw. geführt) werden, vorzugsweise an den (zumindest in der Betriebsstellung) darunter befindlichen Untergrund. Dadurch kann das Medium den Untergrund (zumindest teilweise) benetzen und/oder in diesen (zumindest teilweise) eindringen, insbesondere in und/oder durch Unebenheiten, Risse und/oder Rillen. Alternativ oder zusätzlich kann die Kontakteinheit ein (untenliegendes, nach unten weisendes und/oder mittig angeordnetes) Innengewinde aufweisen, welches dazu eingerichtet ist eine und/oder die Messerweiterung (z. B. einen Erdspieß) reversibel lösbar anzuordnen, z. B. einzuschrauben.

Es ist ferner denkbar, dass das Unterteil eine Entkopplungseinheit aufweist, welche (mechanisch) dazu eingerichtet ist eine, insbesondere lineare und/oder geführte, (durch den Benutzer vorgenommene) Bewegung der Benetzungseinheit relativ zu der Elektrode zu ermöglichen, insbesondere entlang oder entgegen einer Vertikalen.

Die Entkopplungseinheit kann (oben) mit der Benetzungseinheit und/oder der Freigabeeinheit verbunden sein, insbesondere an dieser befestigt sein.

Die Entkopplungseinheit kann (unten) mit der Elektrode verbunden sein, insbesondere an dieser befestigt sein.

Dabei kann die Entkopplungseinheit eingerichtet sein eine Bewegung linear, translatorisch, (gemäß einer [vordefinierten] Beabstandung) begrenzt, und/oder wahlweise ([nur] nach oben und/oder unten) zu ermöglichen. Die Entkopplungseinheit kann die Elektrode und die Benetzungseinheit, insbesondere die Freigabeeinheit, (mechanisch) verbinden, beispielsweise kann eine Oberseite der Entkopplungseinheit mit der Benetzungseinheit verbunden (an dieser befestigt) sein und eine Unterseite der Entkopplungseinheit mit der Elektrode verbunden (an dieser befestigt) sein. Vorzugsweise stellt die Entkopplungseinheit ein (mechanisches) Spiel und/oder einen Freilauf und/oder eine Beweglichkeit zwischen der Elektrode und der Benetzungseinheit, insbesondere der Freigabeeinheit, bereit. Besonders bevorzugt kann es sein, dass die Entkopplungseinheit eingerichtet ist, insbesondere in der Transportstellung, eine (vordefinierte) Beabstandung und/oder einen Bewegungsspielraum zwischen Elektrode und Benetzungseinheit (und/oder Freigabeeinheit) bereitzustellen, wobei die Beabstandung vorzugsweise (exakt) einem Ventilweg des Ventils entspricht.

Dabei (dadurch) kann, insbesondere in einer Betriebsstellung, insbesondere durch das Gewicht der Benetzungseinheit und/oder des Griffs und/oder der Bauteile oberhalb der Entkopplungseinheit, die Entkopplungseinheit (entlang und/oder entgegen der Vertikalen) , insbesondere in Ihrer Ausdehnung, minimiert sein, komprimiert sein und/oder eine minimale Beabstandung zwischen Elektrode und Benetzungseinheit bereitstellen, wobei insbesondere ein Fluss von Medium von dem Vorratstank an/in die Freigabeeinheit gesperrt wird, insbesondere durch das (den Auslass der Freigabeeinheit freigebende, oben anschlagende und/oder [von unten] an einem Einlass der Freigabeeinheit anschlagende) Ventil.

Dabei (dadurch) kann, insbesondere in einer Transportstellung, insbesondere durch das Gewicht der Elektrode, der Kontakteinheit, der Messerweiterung und/oder der Bauteile unterhalb der Entkopplungseinheit, die Entkopplungseinheit (entlang und/oder entgegen der Vertikalen) maximiert sein, dekomprimiert sein, (längs-)gestreckt sein, und/oder eine maximale/vordefinierte Beabstandung zwischen Elektrode und Benetzungseinheit bereitstellen, wobei insbesondere ein Fluss von Medium von dem Vorratstank an/in die Freigabeeinheit (zumindest teilweise, vorzugsweise vollständig) geöffnet/ermöglicht wird, insbesondere durch das (den Einlass der Freigabeeinheit freigebende, unten anschlagende und/oder [von oben] an einem Auslass der Freigabeeinheit und/oder Verbindungsleitung anschlagende) Ventil.

Auch ist es denkbar, dass die Entkopplungseinheit eine Feder und/oder einen Freilauf zwischen der Benetzungseinheit und der Elektrode aufweist.

Vorzugsweise ist die Entkopplungseinheit dazu eingerichtet zumindest zwei Stellungen bereitzustellen, insbesondere eine Betriebsstellung bzw. Betriebskonfiguration (keine bzw. minimale Beabstandung zwischen Elektrode und Benetzungseinheit) und eine Transportstellung bzw. Transportkonfiguration ([vordefinierte] Beabstandung [bzw. Distanz entsprechend einem Ventilweg des Ventils] zwischen Elektrode und Benetzungseinheit).

Dabei kann im einfachsten Fall die Entkopplungseinheit eine (Spiral-)Feder aufweisen, beispielsweise eine Stahlfeder. Zusätzlich oder alternativ kann die Entkopplungseinheit ein anderes mechanisches Bauteil aufweisen, welches eingerichtet ist zumindest zwei Stellungen (und/oder eine Betriebsstellung und eine Transportstellung) bereitzustellen. Dabei kann die Entkopplungseinheit zusätzlich oder alternativ einen Freilauf aufweisen, welcher beispielsweise entlang der Vertikalen und/oder als (entlang der Vertikalen längserstrecktes) Langloch in einem oberen (oder unteren) Teil der Entkopplungseinheit angeordnet ist. In dem Freilauf und/oder Langloch kann ein (komplementär und/oder senkrecht zur Vertikalen ausgebildeter) Bolzen beweglich gelagert angeordnet sein, welcher insbesondere unten/am unteren (oder oberen) Teil der Entkopplungseinheit angeordnet ist. Dabei kann der Bolzen in dem Freilauf und/oder Langloch in der Betriebsstellung oben anschlagen. Dabei kann der Bolzen in dem Freilauf und/oder Langloch in der Transportstellung unten anschlagen. Alternativ oder zusätzlich kann eine Klemmvorrichtung und/oder Verschraubung vorgesehen sein, wobei insbesondere bei der Nutzung als (reiner) Erdspieß, d.h. ohne Abgabe von Medium / Flüssigkeit, die Entkopplungseinheit keinen Weg zurücklegt. Dies kann den Verschleiß reduzieren. Dadurch können zumindest zwei Stellungen bzw. eine Betriebsstellung und eine Transportstellung bereitgestellt werden. Auch eine Kombination von Feder und Freilauf ist denkbar. Die Feder kann eine Dämpfung bereitstellen. Der Freilauf kann einen (harten und/oder fixen) oberen und/oder unteren Anschlag bereitstellen.

Auch andere Ausgestaltungen der Entkopplungseinheit sind denkbar. So kann die Entkopplungseinheit beispielsweise einen Zylinder aufweisen und/oder als solcher ausgestaltet sein, beispielsweise einen (als) Hubzylinder.

Im Rahmen der Erfindung ist es optional möglich, dass die Benetzungseinheit (und/oder der Griff) relativ zu der Elektrode, insbesondere durch eine Bewegung des Griffes und/oder an dem Griff, insbesondere entlang oder entgegen einer Vertikalen (nach oben oder unten), insbesondere durch den Benutzer, zumindest bewegbar ist (bewegt wird/werden kann) zwischen (zumindest zwei Stellungen, insbesondere)
- einer Betriebsstellung (bzw. in einer Betriebskonfiguration), in welcher das Medium von der Benetzungseinheit an die Elektrode bereitgestellt wird, wobei insbesondere ein Ventil (und/oder Ventiloberteil) zwischen der Benetzungseinheit und der Elektrode zumindest teilweise (und/oder vollständig) geöffnet ist, und
- einer Transportstellung (bzw. in einer Transportkonfiguration), in welcher kein (kaum ein) Medium von der Benetzungseinheit an die Elektrode bereitgestellt wird, wobei insbesondere das Ventil (und/oder ein Ventiloberteil) zwischen der Benetzungseinheit und der Elektrode sperrt (gesperrt ist) und/oder schließt und/oder geschlossen ist.

Die Betriebsstellung kann dafür eingerichtet sein, das Medium von der Benetzungseinheit über und/oder durch die Elektrode an einen (darunter befindlichen) Untergrund abzugeben. Dadurch kann dieser vorteilhafterweise durch das Medium benetzt werden und/oder durchsickert und/oder durchweicht werden. Dadurch kann vorteilhafterweise die elektrische Leitfähigkeit und/oder (Mess-)Genauigkeit verbessert werden. In der Betriebsstellung kann die Vorrichtung, insbesondere das Unterteil, (durch den Benutzer) auf einem (darunter befindlichen) Untergrund abgestellt sein, beispielsweise einer Straße, einem Gehweg, einem gepflasterten Untergrund, dem Erdboden und/oder einem sonstigen (versiegelten oder unversiegelten) Abschnitt der Erdoberfläche. Vorzugsweise können in der Betriebsstellung das (Eigen-)Gewicht des Griffes, des Verbindungsteils, der Benetzungseinheit, der Freigabeeinheit, des Vorratstanks und/oder der Komponenten oberhalb der Entkopplungseinheit, die Entkopplungseinheit (maximal) komprimieren und/oder zusammendrücken, wobei insbesondere die Elektrode und die Benetzungseinheit (und/oder die Freigabeeinheit) minimal voneinander beabstandet sein können.

Die Transportstellung kann für einen Transport der Vorrichtung eingerichtet sein. Dabei kann der Benutzer die Vorrichtung, vorzugsweise durch Handhabung über den Griff, bewegen. Dabei kann die Vorrichtung (entlang der Vertikalen) von einem darunter befindlichen Untergrund beabstandet sein und/oder senkrecht zu der Vertikalen bewegt werden, beispielsweise um die Vorrichtung von einer Messposition auf dem Untergrund zu einer weiteren Messposition zu transportieren/bewegen. Vorzugsweise sperrt das Ventil dabei einen Fluss von Medium, insbesondere zwischen der Benetzungseinheit und der Elektrode. Dadurch kann vorteilhafterweise ein (unerwünschtes) Austreten von Medium (während eines Transports) verhindert werden. Das Ventil kann dabei vorzugsweise dafür und/oder derart eingerichtet sein, mechanisch und/oder automatisch betätigt zu werden, wenn (der Benutzer) die Vorrichtung (am Griff) von der Betriebsstellung (ausgehend) und/oder entlang der Vertikalen (nach oben) anhebt. Dadurch können vorteilhafterweise Komfort, Einfachheit, Effizienz und/oder Geschwindigkeit verbessert werden. Vorzugsweise können in der Transportstellung das (Eigen-)Gewicht der Elektrode und/oder der Komponenten unterhalb der Entkopplungseinheit, die Entkopplungseinheit (maximal) dekomprimieren und/oder auseinander ziehen, wobei insbesondere die Elektrode und die Benetzungseinheit (und/oder die Freigabeeinheit) maximal voneinander beabstandet sein können. Alternativ oder zusätzlich kann es vorgesehen sein, dass das Ventil mechanisch und/oder händisch betätigbar ausgestaltet ist. Dabei kann ein Bowdenzug in Verbindung mit einem vom Benutzer zu betätigenden Hebel, z. B. ähnlich einer Fahrradbremse oder eines (eindrückbaren) Knopfes, verwendet werden. Über den Hebel kann der Bowdenzug betätigt werden, der wiederum das Ventil betätigt, sodass Medium aus dem Freigabetank zur Elektrode gelangen kann. Gleichzeitig kann das Ventil den Vorratstank zum Freigabetank für die Zeit der Betätigung sperren, sodass lediglich das Medium aus dem Freigabetank entweichen kann.

Beispielsweise kann dies realisiert werden, indem das Ventil zumindest teilweise und/oder an einem untenliegenden Ventilunterteil (direkt oder indirekt mechanisch) mit der Elektrode und/oder (einem unteren Teil) der Entkopplungseinheit verbunden ist (z. B. verschraubt). Das Ventil und/oder ein obenliegendes Oberteil des Ventils kann dafür eingerichtet sein, in der Transportstellung einen Fluss von Medium (in Richtung der Elektrode) zu sperren und/oder zu blockieren, z. B. durch ein (unteres) Anschlagen an einem unteren Anschlagpunkt und/oder einem Auslass der Benetzungseinheit, insbesondere der Freigabeeinheit und/oder (einem oberen Ende) einer Verbindungsleitung. Es kann vorgesehen sein, dass das Ventil (mechanisch) im Zusammenspiel mit der Entkopplungseinheit die Transportstellung und die Betriebsstellung bereitstellt, welche insbesondere durch den Benutzer und/oder durch Bedienen des Griffes wahlweise eingestellt werden kann.

Ferner kann es im Rahmen der Erfindung vorgesehen sein, dass die Benetzungseinheit eine Freigabeeinheit aufweist, welche dazu eingerichtet ist das Medium, insbesondere ein vordefiniertes Volumen (z. B. definiert über ein Volumen der Freigabeeinheit und/oder eines Freigabetanks und/oder der Verbindungsleitung(en) zwischen Freigabetank und Elektrode) des Mediums, an die Elektrode abzugeben, vorzugsweise über eine mit der Elektrode verbundene (unterhalb eines Freigabetanks angeordnete und mit diesem verbundene) Verbindungsleitung für das Medium, wobei insbesondere
- die Freigabeeinheit, insbesondere die Verbindungsleitung, mit der zumindest einen Durchführung der Elektrode (mediumführend) verbunden ist, und/oder
- die Freigabeeinheit, insbesondere die Verbindungsleitung, zumindest abschnittsweise flexibel, beispielsweise schlauchartig, ausgestaltet ist, und/oder
- die Freigabeeinheit, insbesondere die Verbindungsleitung, zumindest abschnittsweise rigide, beispielsweise rohrförmig und/oder (hohl-)zylindrisch, ausgestaltet ist.

Es kann vorgesehen sein, dass das (vordefinierte) Volumen variabel und/oder einstellbar ist. Dies kann beispielsweise über eine Einstellbarkeit des Ventilweges erzielt werden. Alternativ oder zusätzlich kann es vorgesehen sein, dass Volumen einer Freigabeeinheit und/oder eines Freigabetanks und/oder der Verbindungsleitung(en) zwischen Freigabetank und Elektrode zu variieren, z. B. durch Ersatz bzw. Umbau. Dadurch kann eine Anpassbarkeit des Volumens erzielt werden, beispielsweise um die Vorrichtung für unterschiedliche Anwendungsfälle (z. B. Untergründe) anzupassen.

Es kann vorgesehen sein, dass die Vorrichtung, der Griff, das Verbindungsteil, die Benetzungseinheit, der Vorratstank, die Freigabeeinheit, der Freigabetank, die Verbindungsleitung und/oder die Elektrode (zumindest abschnittsweise) symmetrisch, insbesondere relativ zu der Vertikalen, ausgestaltet ist.

Die Freigabeeinheit kann einteilig ausgestaltet sein. Die Freigabeeinheit kann einen (obenliegenden) Freigabetank aufweisen. Die Freigabeeinheit und/oder der Freigabetank kann (an einer obenliegenden Seite) einen Einlass zum Befüllen mit Medium aufweisen, woran beispielsweise der Vorratstank angeschlossen ist. Die Freigabeeinheit und/oder der Freigabetank kann (an einer untenliegenden Seite), insbesondere gegenüber dem Einlass, einen Auslass zum Abgeben und/oder Abführen des Mediums aufweisen, insbesondere an die Elektrode, vorzugsweise über eine an dem Auslass angeordnete Verbindungsleitung (welche wiederum mit der Elektrode, insbesondere dem zumindest einen Durchlass, verbunden ist).

Die Freigabeeinheit, insbesondere die Verbindungsleitung, kann mit der zumindest einen Durchführung der Elektrode (mediumführend) verbunden sein. Dabei kann die Verbindungsleitung an einem Auslass der Freigabeeinheit, insbesondere des Freigabetanks, angeschlossen sein.

Vorzugsweise kann dabei ein Abstand zwischen dem Einlass und dem Auslass (im Wesentlichen) dem Ventilweg des Ventils entsprechen und/oder der (vordefinierten) Beabstandung (der Entkopplungseinheit), insbesondere zwischen einem oberen und unteren Anschlagpunkt der Entkopplungseinheit.

In der Betriebsstellung kann das Medium (durch den Auslass) an die Elektrode (über die Verbindungsleitung) abgegeben werden, vorzugsweise durch und/oder aufgrund des geöffneten Ventils, welches idealerweise den Auslass zumindest teilweise, vorzugsweise vollständig, öffnet. In der Betriebsstellung kann vorzugsweise kein Medium (durch den Einlass) in die Freigabeeinheit, insbesondere den (scheibenförmigen) Freigabetank, eingeführt werden, insbesondere von dem Vorratstank aus, vorzugsweise durch und/oder aufgrund des geschlossenen Ventils, welches idealerweise den Auslass zumindest teilweise, vorzugsweise vollständig, verschließt.

In der Transportstellung kann vorzugsweise kein Medium (durch den Auslass) an die Elektrode (über die Verbindungsleitung) abgegeben werden, vorzugsweise durch und/oder aufgrund des geschlossenen Ventils, welches idealerweise den Auslass zumindest teilweise, vorzugsweise vollständig, schließt. In der Transportstellung kann vorzugsweise das Medium (durch den Einlass) in die Freigabeeinheit, insbesondere den (scheibenförmigen) Freigabetank, eingeführt werden, insbesondere von dem Vorratstank aus, vorzugsweise durch und/oder aufgrund des geöffneten Ventils, welches idealerweise den Einlass zumindest teilweise, vorzugsweise vollständig, öffnet.

Die Freigabeeinheit, insbesondere die Verbindungsleitung, kann zumindest abschnittsweise flexibel, beispielsweise schlauchartig, ausgestaltet sein. Beispielsweise kann diese zumindest abschnittsweise als (symmetrischer) flexibler Schlauch, insbesondere mit rundem Querschnitt, ausgestaltet sein, beispielsweise umfassend einen Kunststoff (wie etwa Gummi). Die Freigabeeinheit, insbesondere die Verbindungsleitung, kann (oben) an der Elektrode und/oder der zumindest einen Durchführung angeschlossen sein. Die Freigabeeinheit, insbesondere die Verbindungsleitung, kann (von unten) an der Benetzungseinheit, der Freigabeeinheit und/oder dem Freigabetank, insbesondere dem Auslass, angeschlossen sein. Die Flexibilität kann dabei vorteilhaft sein, um die wechselnde Beabstandung zwischen Benetzungseinheit und Elektrode bzw. Betriebsstellung und Transportstellung zu ermöglichen. Dadurch kann vorteilhafterweise eine rigide und/oder kraftschlüssige Befestigung der Verbindungsleitung an der Elektrode (bzw. der zumindest einen Durchführung) und/oder dem Freigabetank (bzw. dem Auslass) ermöglicht werden. Dies kann die Dichtigkeit gewährleisten und/oder den Verschleiß minimieren.

Die Freigabeeinheit, insbesondere die Verbindungsleitung, kann zumindest abschnittsweise rigide, beispielsweise rohrförmig, ausgestaltet sein. Beispielsweise kann diese zumindest abschnittsweise als (symmetrisches) rigides Rohr, insbesondere mit rundem Querschnitt, ausgestaltet sein, beispielsweise umfassend einen (harten) Kunststoff und/oder ein Metall (etwa Edelstahl). Die Freigabeeinheit, insbesondere die Verbindungsleitung, kann (von unten) an der Benetzungseinheit, der Freigabeeinheit und/oder dem Freigabetank, insbesondere dem Auslass, (rigide und/oder kraftschlüssig) angeschlossen sein (etwa verklebt oder verschweißt). Die Freigabeeinheit, insbesondere die Verbindungsleitung, kann (oben) an der Elektrode und/oder der zumindest einen Durchführung mediumführend und/oder beweglich und/oder mit Spiel angeschlossen sein. Mit anderen Worten kann sich die Verbindungsleitung (zumindest abschnittsweise) innerhalb der Elektrode und/oder der zumindest einen Durchführung bewegen, wobei vorzugsweise durchgehend eine mediumführende Verbindung bereitgestellt wird. Dabei kann in der Betriebsstellung die (rigide) Verbindungsleitung (beispielsweise aufgrund eines geringeren Durchmessers als die zumindest eine Durchführung aufweist), zumindest teilweise in die Elektrode und/oder die zumindest eine Durchführung hineinbewegt werden. Entsprechend kann in der Transportstellung die (rigide) Verbindungsleitung (beispielsweise aufgrund eines geringeren Durchmessers als die zumindest eine Durchführung aufweist), zumindest teilweise aus der Elektrode und/oder der zumindest einen Durchführung herausgezogen werden, wobei vorzugsweise (dennoch) eine mediumführende Verbindung bestehen bleibt (um vorteilhafterweise ein Eindringen von Schmutz zu verhindern).

Die Freigabeeinheit, insbesondere die Verbindungsleitung, kann zumindest abschnittsweise, vorzugsweise vollständig, rigide, beispielsweise rohrförmig, ausgestaltet sein. Beispielsweise kann diese zumindest abschnittsweise, vorzugsweise vollständig, als (symmetrisches) rigides Rohr, insbesondere mit rundem Querschnitt, ausgestaltet sein, beispielsweise umfassend einen (harten) Kunststoff und/oder ein Metall (etwa Edelstahl). Die Freigabeeinheit, insbesondere die Verbindungsleitung, kann (oben) an der Elektrode und/oder der zumindest einen Durchführung (rigide und/oder kraftschlüssig) angeschlossen sein (etwa verklebt oder verschweißt). Die Verbindungsleitung, kann (oben) an der Freigabeeinheit bzw. dem Freigabetank mediumführend und/oder beweglich und/oder mit Spiel angeschlossen sein. Mit anderen Worten kann sich die Verbindungsleitung (zumindest abschnittsweise) innerhalb des Freigabetanks und/oder Auslasses bewegen, wobei vorzugsweise durchgehend eine mediumführende Verbindung bereitgestellt wird. Dies kann vorzugsweise mit einer alternativen Ausgestaltung des Ventils kombiniert werden. Dabei kann das Ventil (mechanisch) durch die (relativ zu dem Freigabetank bewegliche) Verbindungsleitung betätigt werden. Das Ventil kann dabei beispielsweise unmittelbar auf der Verbindungsleitung befestigt sein, und sich mit dieser bewegen. Vorzugsweise kann die Verbindungsleitung am oberen Ende (seitliche) Löcher aufweisen, durch welche das Medium in der Betriebsstellung in die Verbindungsleitung fließen kann. In der Transportstellung kann die Verbindungsleitung (aufgrund ihrer mechanischen Kopplung mit der Elektrode) aus dem Freigabetank bzw. dem Auslass herausgezogen werden, vorzugsweise (genau) so weit, dass das (am oberen Ende der Verbindungsleitung befestigte) Ventil den Auslass verschließt. Dies kann insbesondere auch mit einer (bezogen auf die Vertikale) mittig und/oder symmetrisch verlaufenden Verbindungsleitung kombiniert werden, welche beispielsweise (zumindest abschnittsweise) von (der Feder) der Entkopplungseinheit umgeben ist. So kann beispielsweise die Verbindungsleitung sich innerhalb eines (zentralen) Rohres bewegen. Dabei kann die Verbindungsleitung ein erstes Loch oder eine erste Nut aufweisen, welche (nur) in der Transportstellung zum Befüllen des Freigabetanks den Freigabetank mit dem Vorratstank verbindet. Dabei kann die Verbindungsleitung ein zweites Loch oder eine zweite Nut aufweisen, welche in der Betriebsstellung zum Bereitstellen des Mediums an die Elektrode bzw. die zumindest eine Durchführung, den Freigabetank mit der Elektrode bzw. der ersten Durchführung verbindet.

In Bezug auf die vorliegende Erfindung ist es vorstellbar, dass die Vorrichtung, insbesondere die Benetzungseinheit, einen Vorratstank aufweist, welcher zum Speichern von dem Medium eingerichtet ist, wobei insbesondere der Vorratstank zum Bereitstellen von dem Medium mit der Freigabeeinheit (mediumführend und/oder über einen Schlauch) verbunden ist.

Dabei kann ein (Auslass von dem) Vorratstank, beispielsweise über einen Schlauch, mit (dem Einlass) der Freigabeeinheit und/oder des Freigabetanks verbunden sein. Es ist auch denkbar, dass der Freigabetank direkt auf der Freigabeeinheit und/oder dem Freigabetank (bündig) angeordnet ist. Dabei kann ein Einlass der Freigabeeinheit und/oder des Freigabetanks einem/dem Auslass des Vorratstanks entsprechen (bzw. können diese bündig aneinandergrenzen). Dies kann die Robustheit und/oder das (oberhalb der Entkopplungseinheit befindliche) Gewicht und/oder die Standfestigkeit erhöhen. Dadurch kann die Vorrichtung losgelöst von dem Benutzer verwendet werden, insbesondere zu einer Ausgestaltung, bei welcher der Benutzer den Vorratstank trägt. Der Vorratstank kann beispielsweise zum Speichern von Medium, beispielsweise von einem bis 10 Litern, eingerichtet sein. Bevorzugt umfasst die Freigabeeinheit und/oder der Freigabetank und/oder die Verbindungsleitung ein geringeres Volumen als der Vorratstank, beispielsweise zwischen 10 und 100 Milliliter. Dadurch kann die Freigabeeinheit wiederholt (in der Transportstellung) durch Medium aus dem Vorratstank gefüllt werden, insbesondere durch mehrfachen Wechsel zwischen der Betriebsstellung und der Transportstellung. Der Vorratstank kann einen (verschließbaren und/oder an der Oberseite befindlichen) Einlass zum Befüllen mit Medium, beispielsweise über einen Wasserhahn, aufweisen. Der Vorratstank und/oder der Freigabetank und/oder die Freigabeeinheit können (im Wesentlichen) (hohl-)zylindrisch ausgestaltet sein, etwa wie eine (oben und unten geschlossene) Tonne.

Ferner ist es vorstellbar, dass der Vorratstank separat von der Benetzungseinheit, beispielsweise auf dem Rücken des Benutzers, anordenbar ist, wobei insbesondere der Vorratstank zur Bereitstellung von Medium über einen Einlass der Freigabeeinheit mit der Freigabeeinheit verbunden ist, vorzugsweise über einen Schlauch. Hierbei können der und/oder die Vorratstanks ein größeres Volumen, bspw. bis zu ca. 20 bis 30 Litern, aufweisen.

Dabei kann ein (Auslass von dem) Vorratstank, beispielsweise über einen Schlauch, mit (dem Einlass) der Freigabeeinheit und/oder des Freigabetanks verbunden sein. Demnach kann der Vorratstank ähnlich und/oder wie ein Rucksack ausgestaltet sein. Dadurch kann vorteilhafterweise der Schwerpunkt der Vorrichtung (noch weiter) in Richtung des Untergrunds und/oder der Elektrode verlagert werden. Dies kann die Standfestigkeit, Sicherheit, Positionierung und/oder (Mess-)Genauigkeit (weiter) optimieren. Zudem kann dies die Sicherheit und/oder den Komfort optimieren, insbesondere da für einen Benutzer das Tragen auf dem Rücken (wie bei einem Rucksack) angenehmer sein kann als das Gewicht über den Griff zu bewegen. Dadurch kann insbesondere vorteilhafterweise das Gewicht der Vorrichtung, welche insbesondere durch den Griff bewegt werden kann, verringert werden. Dies kann die Sicherheit und/oder den Komfort (insgesamt) verbessern. Zudem kann die Menge an Medium durch die genannten Vorteile vergrößert werden.

Im Rahmen der Erfindung kann es von Vorteil sein, dass die Benetzungseinheit, und/oder insbesondere das Unterteil, den Vorratstank umfasst, wobei insbesondere
- der Vorratstank oberhalb von der Freigabeeinheit angeordnet ist,
- der Vorratstank einen, insbesondere obenliegenden, Entlüftungskanal aufweist, und/oder
- die Freigabeeinheit einen Entlüftungskanal aufweist, welcher vorzugsweise zumindest abschnittsweise in dem Vorratstank angeordnet ist, wobei vorzugsweise der Entlüftungskanal der Freigabeeinheit durch den Vorratstank führt.

Es ist auch denkbar, dass der Freigabetank direkt und/oder oben auf der Freigabeeinheit und/oder dem Freigabetank (bündig) angeordnet ist. Dabei kann ein Einlass der Freigabeeinheit und/oder des Freigabetanks einem/dem Auslass des Vorratstanks entsprechen (bzw. können diese bündig aneinandergrenzen). Dies kann die Robustheit und/oder das (oberhalb der Entkopplungseinheit befindliche) Gewicht und/oder die Standfestigkeit erhöhen. Dabei kann der Vorratstank einen, insbesondere obenliegenden, Entlüftungskanal aufweisen, welcher dafür eingerichtet, insbesondere in der Transportstellung, Luft von außerhalb der Vorrichtung in den Vorratstank einströmen zu lassen, um eine Abgabe von Medium aus dem Vorratstank an die Freigabeeinheit zu ermöglichen / erleichtern. Dabei kann der Entlüftungskanal beispielsweise als Loch und/oder Ventil in der Oberseite und/oder der Wandung des Vorratstanks vorgesehen sein. Es kann vorgesehen sein, dass der Entlüftungskanal ein Rückschlagventil aufweist, welches ein Austreten von Medium durch den Entlüftungskanal verhindert (z. B. wenn die Vorrichtung umfallen sollte).

Dabei kann die Freigabeeinheit einen Entlüftungskanal aufweisen, welcher vorzugsweise zumindest abschnittsweise in dem Vorratstank angeordnet ist, wobei vorzugsweise der Entlüftungskanal der Freigabeeinheit (vollständig) durch den Vorratstank führt. Beispielsweise kann der Entlüftungskanal als Rohr ausgestaltet sein. Der Entlüftungskanal der Freigabeeinheit kann beispielsweise von der Oberseite der Freigabeeinheit, insbesondere durch den Vorratstank, zu einer Oberseite des Vorratstanks führen. Dadurch kann der Entlüftungskanal ein Einströmen von Luft in die Freigabeeinheit, insbesondere in der Betriebsstellung, ermöglichen, so dass vorzugsweise das Medium aus der Freigabeeinheit an die Elektrode abgegeben werden kann. Es kann vorgesehen sein, dass der Entlüftungskanal ein Rückschlagventil aufweist, welches ein Austreten von dem Medium durch den Entlüftungskanal verhindert (z. B. wenn die Vorrichtung umfallen sollte).

Der Entlüftungskanal kann auch (vollständig) außerhalb des Vorratstanks angeordnet sein, insbesondere bei einer Variante als Rucksack. Auch bei einer Ausführung mit benachbartem Freigabeeinheit und Vorratstank kann es, insbesondere in der Produktion, kostengünstiger und/oder zur Verbesserung der Dichtigkeit besser / einfacher zu realisieren sein, wenn der Entlüftungskanal der Freigabeeinheit /-tank außerhalb des Vorratstanks verläuft.

Alternativ oder zusätzlich kann ein gemeinsamer Entlüftungskanal vorgesehen sein, wobei beispielsweise (nahe der Oberseite des Vorratstanks) der Entlüftungskanal der Freigabeeinheit und der Entlüftungskanal des Vorratstanks miteinander verbunden sind. Dadurch kann die Anzahl der Öffnungen, durch die potentiell Schmutz eindringen kann, reduziert werden. Es kann vorgesehen sein, dass der gemeinsame Entlüftungskanal ein Rückschlagventil aufweist, welches ein Austreten von dem Medium durch den Entlüftungskanal verhindert (z. B. wenn die Vorrichtung umfallen sollte).

Im Rahmen der Erfindung ist es denkbar, dass das Unterteil (der Vorrichtung) ein Ventil aufweist, welches zumindest abschnittsweise, insbesondere an einem untenliegenden Ventilunterteil, mit der Elektrode (direkt oder indirekt, etwa über ein Verbindungsteil) in mechanischer Wirkverbindung steht, wodurch vorzugsweise das Ventilunterteil starr mit der Elektrode gekoppelt und/oder zumindest abschnittsweise unterhalb der Entkopplungseinheit angeordnet ist. Alternativ oder zusätzlich ist (neben einer mechanischen Wirkverbindung) auch eine elektro-pneumatische und/oder rein elektrische Verbindung.

Das Ventil kann dabei stangenartig und/oder längserstreckt ausgestaltet sein. Dabei kann das Ventiloberteil abgewinkelt ausgestaltet sein, um insbesondere einen bündigen Schluss mit dem Einlass und/oder Auslass (der Freigabeeinheit und/oder des Freigabetanks) bereitzustellen. Das Ventilunterteil kann kraft- und/oder formschlüssig an der Elektrode, der Entkopplungseinheit (einem unteren Teil davon) und/oder an einem Verbindungsteil zwischen Elektrode und Entkopplungseinheit befestigt sein. Vorzugsweise bewegt sich das Ventil, das Ventiloberteil und/oder Ventilunterteil nicht relativ zu der Elektrode. Vorzugsweise bewegt sich das Ventil, das Ventiloberteil und/oder Ventilunterteil zusammen und/oder gekoppelt mit der Elektrode.

Es kann im Rahmen der Erfindung vorgesehen sein, dass das Ventil zumindest abschnittsweise, insbesondere an einem obenliegenden Ventiloberteil, dazu eingerichtet ist, einen Fluss von Medium von der Benetzungseinheit zu der Elektrode (wahlweise und/oder in der Betriebsstellung) zu ermöglichen (oder zu sperren), insbesondere in Abhängigkeit von einer Bewegung des Benutzers an dem Griff, insbesondere entlang oder entgegen einer Vertikalen, wobei vorzugsweise
- in der Betriebsstellung, das Ventil, insbesondere das Ventiloberteil,
   ∘ einen Fluss von dem Medium von dem Vorratstank in die Freigabeeinheit sperrt, und
   ∘ einen Fluss von dem Medium von der Freigabeeinheit zur Elektrode ermöglicht, und/oder
- in der Transportstellung, das Ventil, insbesondere das Ventiloberteil,
   ∘ einen Fluss von dem Medium von dem Vorratstank in die Freigabeeinheit ermöglicht, und
   ∘ einen Fluss von dem Medium von der Freigabeeinheit zur Elektrode sperrt.

Dabei kann der Benutzer (an dem Griff) die Vorrichtung (entlang der Vertikalen) nach oben bewegen, um von der Betriebsstellung in die Transportstellung zu wechseln. Dabei kann der Benutzer (an dem Griff) die Vorrichtung (entgegen der Vertikalen) nach unten bewegen (absetzen), um von der Transportstellung in die Betriebsstellung zu wechseln.

Das Ventil und/oder das Ventiloberteil kann dazu eingerichtet sein, wahlweise den Einlass oder den Auslass der Freigabeeinheit zu verschließen (bzw. zu öffnen).

Das Ventiloberteil kann eingerichtet sein, um (durch eine nach oben weisende Seite) den Einlass der Freigabeeinheit und/oder des Freigabetanks zu verschließen, insbesondere in der Betriebsstellung. In der Betriebsstellung kann das Ventiloberteil vorzugsweise den Auslass öffnen und/oder nicht verschließen. Dadurch kann die Freigabeeinheit das darin enthaltene Medium (vollständig) an die Elektrode (über die Verbindungsleitung) abgeben, insbesondere bis die Freigabeeinheit entleert ist.

Das Ventiloberteil kann eingerichtet sein, um (durch eine nach unten weisende Seite) den Auslass der Freigabeeinheit und/oder des Freigabetanks zu verschließen, insbesondere in der Transportstellung. In der Transportstellung kann das Ventiloberteil vorzugsweise den Einlass öffnen und/oder nicht verschließen. Dadurch kann die Freigabeeinheit mit dem Medium aus dem Vorratstank befüllt werden, insbesondere bis die Freigabeeinheit voll ist.

Es ist ferner denkbar, dass, insbesondere an dem Unterteil und/oder dem Verbindungsteil und/oder der Benetzungseinheit, insbesondere dem Vorratstank, eine Halterung vorgesehen ist, an welcher zumindest eine Messerweiterung, insbesondere ein Erdspieß, reversibel lösbar befestigbar ist, wobei insbesondere ein weiteres Ventil vorgesehen ist, welches zwischen der Benetzungseinheit, insbesondere der Freigabeeinheit, und der Elektrode angeordnet ist.

Die Messerweiterung kann elektrisch leitend ausgestaltet sein. Die Messerweiterung kann beispielsweise ein Metall, etwa Edelstahl, aufweisen. Die Messerweiterung kann dabei ein (in einem oberen Abschnitt und/oder [an der Oberfläche] außenliegendes) Außengewinde aufweisen, welches vorzugsweise identisch zu dem Außengewinde der Kontakteinheit und/oder komplementär zu dem Innengewinde der Elektrode ausgestaltet ist. Die Messerweiterung kann reversibel lösbar befestigt werden, vorzugsweise werkzeuglos. Dadurch kann die Messerweiterung wahlweise und/oder alternativ zu der Kontakteinheit verwendet werden. Die Messerweiterung kann optional verwendet werden. Die Messerweiterung kann für speziellen Untergrund eingerichtet sein. So kann die Messerweiterung beispielsweise einen Erdspieß aufweisen, welcher vorzugsweise (am unteren Ende) spitz zulaufend ausgebildet ist. Dadurch kann dieser in weichem Untergrund (etwa Erde, Wiese, Acker und dergleichen) versenkt werden. Dies kann die Messung verbessern, insbesondere da ein elektrisch gut leitender Kontakt weiter in den Untergrund vordringen kann. Es können eine oder mehrere Halterungen vorgesehen sein. Die Halterung kann komplementär zu der Messerweiterung und/oder der Kontakteinheit ausgestaltet sein. Dadurch können diese (bei Nichtverwendung) an der Halterung reversibel lösbar befestigt werden, beispielsweise werkzeuglos (etwa durch Einklemmen und/oder Einclipsen). Bevorzugt kann es vorgesehen sein, dass die zumindest eine Durchführung und/oder einer (oder mehrere) der Kanäle, nahe und/oder oberhalb von dem und/oder in dem Innengewinde (der Elektrode) und/oder der (montierten) Messerweiterung einen Auslass aufweisen. Dadurch kann das Medium (durch die Elektrode) direkt an die Messerweiterung bereitgestellt werden und insbesondere an dieser (bzw. deren Außenseite) entlangfließen. Dadurch kann die Messung weiter verbessert werden, insbesondere da das/ein (leitfähige(s)) Medium (noch) weiter in den Untergrund eindringen kann. Alternativ oder zusätzlich kann die Messerweiterung auch an der Kontakteinheit befestigt werden und/oder mit dieser (gleichzeitig) verwendet werden. Dies kann die (elektrische und/oder mechanische) Kontaktierung zwischen Vorrichtung und Untergrund weiter verbessern.

Es kann ein weiteres Ventil vorgesehen sein, welches zwischen der Benetzungseinheit, insbesondere der Freigabeeinheit, und der Elektrode und/oder in der Verbindungsleitung angeordnet ist. Das weitere Ventil kann ein Zwei-Wege-Ventile und/oder Drehventile aufweisen. Das weitere Ventil kann vorzugsweise von außen zugänglich und/oder handbetätigbar sein (durch den Benutzer). Dadurch kann der Benutzer (wahlweise) über das weitere Ventil eine Abgabe von dem Medium an die Elektrode sperren (oder öffnen). Dies kann vorteilhaft sein, wenn eine Messerweiterung verwendet wird und/oder wenn das Ventil nicht vollständig schließt (beispielsweise während einer Lagerung, bei welcher keine Messung vorgesehen ist). Dieses kann, insbesondere in der Transportstellung, (zusätzlich) gesperrt werden, um vorteilhafterweise eine (unerwünschte) Abgabe von dem Medium, insbesondere ein Leerlaufen der Freigabeeinheit, des Vorratstanks und/oder der Benetzungseinheit zu verhindern.

Zusätzlich oder alternativ kann eine weitere Halterung vorgesehen sein, welche insbesondere dazu eingerichtet ist, die Kontakteinheit reversibel lösbar, insbesondere werkzeuglos, an der Vorrichtung zu befestigen, insbesondere an einem Verbindungsteil (zwischen Griff und Benetzungseinheit). Dadurch kann dieses griffbereit mitgeführt werden und im Bedarfsfall sofort eingesetzt werden.

Gemäß einem zweiten Aspekt betrifft die vorliegende Erfindung ferner ein Messsystem umfassend eine Steuereinheit, insbesondere eine Erdschlusssonde und/oder umfassend eine Recheneinheit und/oder eine Speichereinheit, und eine Vorrichtung gemäß dem ersten Aspekt, wobei die Steuereinheit dafür eingerichtet ist die Vorrichtung, insbesondere die (mit der Steuereinheit verbundene) Elektrode, anzusteuern und/oder mit Strom und/oder Spannung zu beaufschlagen, um eine Messung, beispielsweise eines elektrischen Potentials und/oder eines Messstroms, bereitzustellen und/oder diesen zu erfassen.

Das Messsystem kann eine oder zumindest (genau) zwei Vorrichtung(en) aufweisen, welche insbesondere identisch ausgestaltet sein können. Insofern können die beschriebenen Ausführungen für eine oder alle Vorrichtungen eines Messsystems gelten. Dabei kann ein (gemessenes) Potential zwischen zwei Vorrichtungen (durch die Steuereinheit und/oder über entsprechende elektrische Leitungen) abgegriffen werden. Eine (jede) Vorrichtung kann demnach eine Messleitung zwischen Elektrode und Messeinheit aufweisen. Demnach können auch zwei (oder mehr) Vorrichtungen gemäß dem ersten Aspekt zeitgleich und/oder in Verbindung mit einer Steuereinheit betrieben werden, insbesondere im Rahmen eines Messsystems gemäß dem zweiten Aspekt.

Damit ergeben sich in Bezug auf ein erfindungsgemäßes Messsystem gemäß dem zweiten Aspekt die gleichen Vorteile, wie sie bereits in Bezug auf eine erfindungsgemäße Vorrichtung gemäß dem ersten Aspekt beschrieben worden sind.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei zeigen beispielhaft
- Fig. 1: eine Vorrichtung 100 in Betriebsstellung I,
- Fig. 2: eine Vorrichtung 100 mit Kontakteinheit 70 in Betriebsstellung I,
- Fig. 3: eine Vorrichtung 100 in Transportstellung II,
- Fig. 4: eine Vorrichtung 100 mit Kontakteinheit 70 in Transportstellung II,
- Fig. 5: eine Vorrichtung 100 mit Messerweiterung 80 in Betriebsstellung I,
- Fig. 6: eine Vorrichtung 100 mit Messerweiterung 80 in Transportstellung II, und
- Fig. 7: ein Messsystem 1000 mit einer Vorrichtung 100 in Betriebsstellung I.

In den Figuren werden für die gleichen technischen Merkmale, auch von unterschiedlichen Ausführungsbeispielen, die identischen Bezugszeichen verwendet.

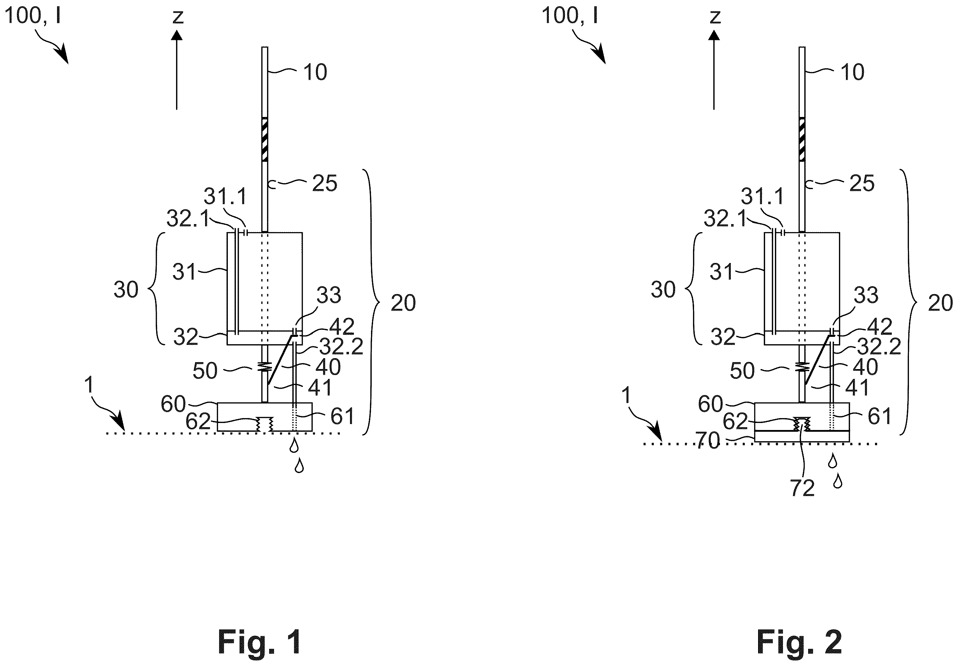

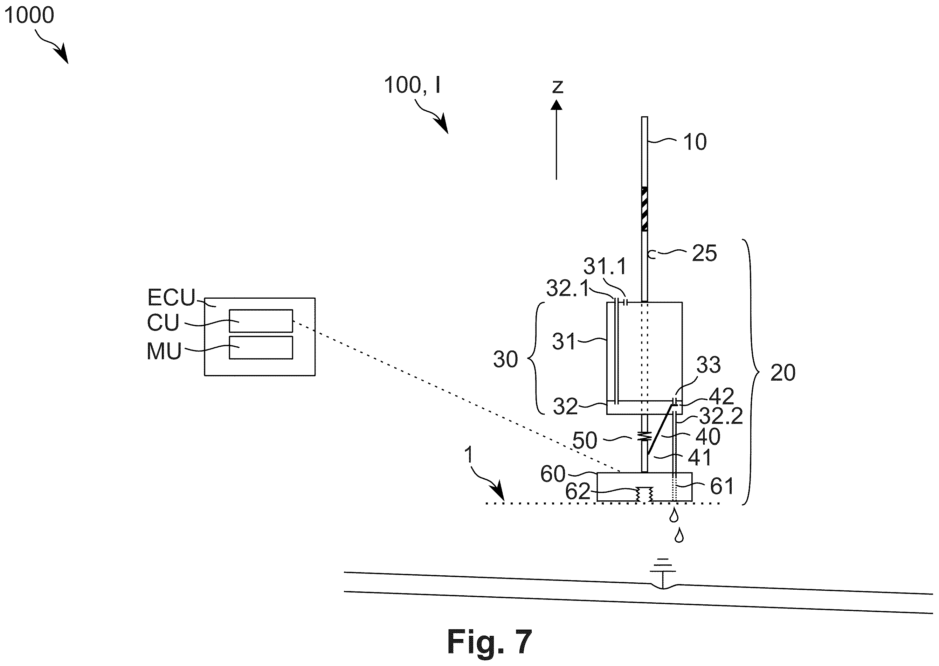

Die Figur 1 (sowie die Figuren 2 bis 6) zeigen eine Vorrichtung 100 für ein Messsystem 1000 (gezeigt in Figur 7), insbesondere umfassend eine Erdschlusssonde, die Vorrichtung 100 aufweisend:
- einen Griff 10, welcher eingerichtet ist, von einem Benutzer bedient zu werden, um die Vorrichtung 100 zu bewegen, wobei insbesondere ein (elektrisch isolierender) Isolationsabschnitt (schraffiert) dargestellt ist,
- ein Unterteil 20, das mit dem Griff 10 verbunden ist und, insbesondere relativ zu einer Vertikalen z, unterhalb von dem Griff 10 angeordnet ist, das Unterteil 20 aufweisend:
   ∘ eine Elektrode 60, welche in einem unteren Abschnitt des Unterteils 20 angeordnet ist,
   ∘ eine Benetzungseinheit 30, welche zumindest abschnittsweise oberhalb der Elektrode 60 angeordnet ist, wobei die Benetzungseinheit 30 dazu eingerichtet ist, ein leitfähiges Medium an die Elektrode 60 bereitzustellen.

Im Rahmen der Erfindung kann es von Vorteil sein, dass die Benetzungseinheit 30, insbesondere in einer Betriebsstellung I, dazu eingerichtet ist, das Medium (siehe angedeutete Tropfen in Figur 1, 2 und 5), insbesondere eine leitfähige Flüssigkeit, an die Elektrode 60 bereitzustellen, wobei die Elektrode 60, insbesondere über zumindest eine Durchführung 61, vorzugsweise eine Bohrung, das Medium an einen unterhalb der Elektrode 60 anordenbaren Untergrund 1 abgebbar ist.

Im Rahmen der Erfindung ist es denkbar, dass die Elektrode 60, insbesondere eine Unterseite der Elektrode 60, flach und/oder plattenförmig ausgestaltet ist.

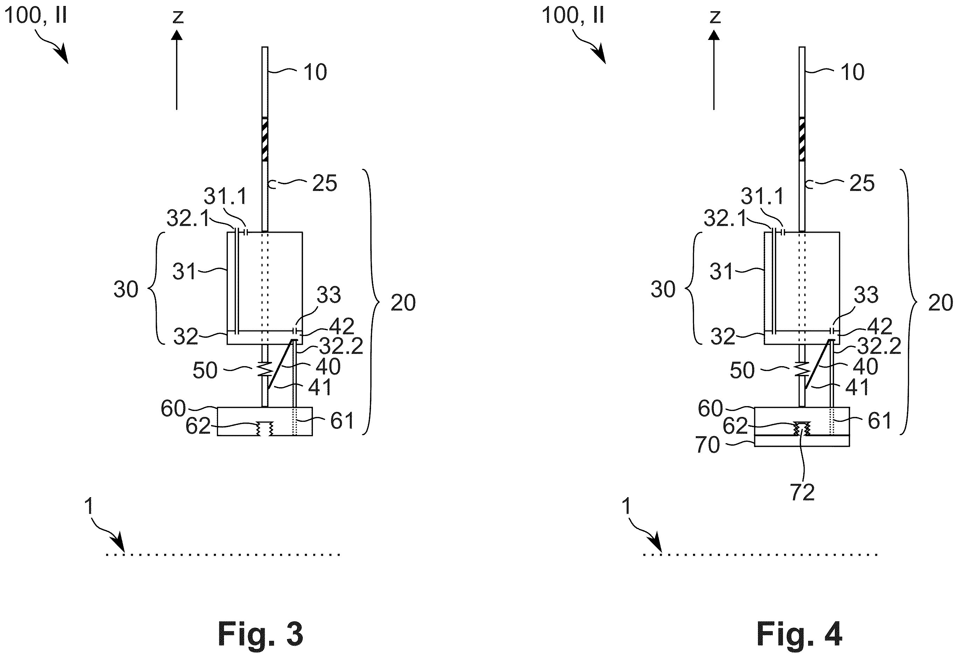

Die Figuren 2 und 4 zeigen, dass es im Rahmen der Erfindung vorgesehen sein kann, dass die Elektrode 60, insbesondere an der Unterseite, eine Kontakteinheit 70 aufweist, welche dazu eingerichtet ist das Medium zumindest teilweise zu verteilen, und insbesondere zu speichern, wobei die Kontakteinheit 70 an der Elektrode 60 reversibel lösbar anordenbar ist, insbesondere über ein Innengewinde 62 der Elektrode 60, welches mit einem Außengewinde 72 der Kontakteinheit 70 in Eingriff gebracht werden kann.

Es ist ferner denkbar, dass das Unterteil 20 eine Entkopplungseinheit 50 aufweist, welche dazu eingerichtet ist, eine, insbesondere lineare und/oder geführte, Bewegung der Benetzungseinheit 30 relativ zu der Elektrode 60 zu ermöglichen, insbesondere entlang oder entgegen einer Vertikalen z. Dies ist insbesondere im Vergleich zwischen den Figuren 1 und 3 bzw. den Figuren 2 und 4 bzw. den Figuren 5 und 6 ersichtlich.

Auch ist es denkbar, dass die Entkopplungseinheit 50 eine Feder oder einen Freilauf zwischen der Benetzungseinheit 30 und der Elektrode 60 aufweist. Dabei sind in den Figuren 1 bis 7 beispielhaft Federn 50 dargestellt. Allerdings kann alternativ oder zusätzlich auch ein Freilauf, beispielsweise in Verbindung mit einem (in diesem beweglichen) Bolzen, verwendet werden (siehe oben).

Im Rahmen der Erfindung ist es optional möglich, dass die Benetzungseinheit 30 relativ zu der Elektrode 60, insbesondere durch eine Bewegung des Griffes 10, insbesondere entlang oder entgegen einer Vertikalen z, durch den Benutzer zumindest bewegbar ist zwischen
- einer Betriebsstellung I, in welcher das Medium von der Benetzungseinheit 30 an die Elektrode 60 bereitgestellt wird, wobei insbesondere ein Ventil 40 zwischen der Benetzungseinheit 30 und der Elektrode 60 zumindest teilweise geöffnet ist, und
- einer Transportstellung II, in welcher kein Medium von der Benetzungseinheit 30 an die Elektrode 60 bereitgestellt wird, wobei insbesondere das Ventil 40 zwischen der Benetzungseinheit 30 und der Elektrode 60 sperrt.

Die Figuren 1, 2 und 5 (und auch Figur 7) zeigen dabei eine Betriebsstellung I, wobei die Vorrichtung 100 (direkt) auf dem darunter befindlichen Untergrund 1 abgestellt ist. Dabei kann die Entkopplungseinheit 50 (durch das Eigengewicht der Benetzungseinheit 30) komprimiert sein und/oder eine minimale Beabstandung aufweisen. Die Benetzungseinheit 30 ist dabei minimal beabstandet von der Elektrode 60.

Die Figuren 3, 4 und 6 zeigen dabei eine Transportstellung II, wobei die Vorrichtung 100 von dem darunter befindlichen Untergrund 1 beabstandet ist (z. B. um die Vorrichtung 100 an eine andere Messposition zu tragen). Dabei kann die Entkopplungseinheit 50 (durch das Eigengewicht der Elektrode 60) dekomprimiert sein und/oder eine maximale Beabstandung aufweisen. Die Benetzungseinheit 30 ist dabei maximal beabstandet von der Elektrode 60.

Ferner kann es im Rahmen der Erfindung vorgesehen sein, dass die Benetzungseinheit 30 eine Freigabeeinheit 32 aufweist, welche dazu eingerichtet ist, das Medium, insbesondere ein vordefiniertes, ggf. einstellbares Volumen des Mediums, an die Elektrode 60 abzugeben, vorzugsweise über eine mit der Elektrode 60 verbundene Verbindungsleitung 32.2 für das Medium, wobei insbesondere
- die Freigabeeinheit 32, insbesondere die Verbindungsleitung 32.2, mit der zumindest einen Durchführung 61 der Elektrode 60 verbunden ist, und/oder
- die Freigabeeinheit 32, insbesondere die Verbindungsleitung 32.2, zumindest abschnittsweise flexibel ausgestaltet ist, und/oder
- die Freigabeeinheit 32, insbesondere die Verbindungsleitung 32.2, zumindest abschnittsweise rigide ausgestaltet ist.

In Bezug auf die vorliegende Erfindung ist es vorstellbar, dass die Vorrichtung 100, insbesondere die Benetzungseinheit 30, einen Vorratstank 31 aufweist, welcher zum Speichern von Medium eingerichtet ist, wobei insbesondere der Vorratstank 31 zum Bereitstellen von Medium mit der Freigabeeinheit 32 verbunden ist.

Ferner ist es vorstellbar, dass der Vorratstank 31 separat von der Benetzungseinheit 30, beispielsweise auf dem Rücken des Benutzers (nicht dargestellt), anordenbar ist, wobei insbesondere der Vorratstank 31 zur Bereitstellung von Medium über einen Einlass 33 der Freigabeeinheit 32 mit der Freigabeeinheit 32 verbunden ist, vorzugsweise über einen Schlauch.

Im Rahmen der Erfindung kann es von Vorteil sein, dass die Benetzungseinheit 30 den Vorratstank 31 umfasst, wobei insbesondere
- der Vorratstank 31 (direkt) oberhalb von der Freigabeeinheit 32 angeordnet ist,
- der Vorratstank 31 einen, insbesondere obenliegenden, Entlüftungskanal 31.1 aufweist, und/oder
- die Freigabeeinheit 32 einen Entlüftungskanal 32.1 aufweist, welcher vorzugsweise zumindest abschnittsweise in dem Vorratstank 31 angeordnet ist, wobei vorzugsweise der Entlüftungskanal 32.1 der Freigabeeinheit 32 durch den Vorratstank 31 führt.

Im Rahmen der Erfindung ist es denkbar, dass das Unterteil 20 ein Ventil 40 aufweist, welches zumindest abschnittsweise, insbesondere an einem untenliegenden Ventilunterteil 41, mit der Elektrode 60 in (mechanischer) Wirkverbindung steht, wodurch vorzugsweise der Ventilunterteil 41 starr mit der Elektrode 60 gekoppelt und/oder zumindest abschnittsweise unterhalb der Entkopplungseinheit 50 (beispielsweise an der Elektrode 60 selbst oder an einer Verbindung zwischen Entkopplungseinheit 50 und Elektrode 60) angeordnet ist.

Es kann im Rahmen der Erfindung vorgesehen sein, dass das Ventil 40 zumindest abschnittsweise, insbesondere an einem obenliegenden Ventiloberteil 42, dazu eingerichtet ist, einen Fluss von Medium von der Benetzungseinheit 30 zu der Elektrode 60 zu ermöglichen, insbesondere in Abhängigkeit von einer Bewegung des Benutzers an dem Griff 10, insbesondere entlang oder entgegen einer Vertikalen z, wobei vorzugsweise
- in der Betriebsstellung I, das Ventil 40, insbesondere das Ventiloberteil 42,
   ∘ einen Fluss von Medium von dem Vorratstank 31 in die Freigabeeinheit 32 sperrt, und
   ∘ einen Fluss von Medium von der Freigabeeinheit 32 zur Elektrode 60 ermöglicht, und
- in der Transportstellung II, das Ventil 40, insbesondere das Ventiloberteil 42,
   ∘ einen Fluss von Medium von dem Vorratstank 31 in die Freigabeeinheit 32 ermöglicht, und
   ∘ einen Fluss von Medium von der Freigabeeinheit 32 zur Elektrode 60 sperrt.

Die Funktionsweise des Ventils 40 wird beispielsweise anhand den folgenden Figuren ersichtlich:
- Figur 1 im Vergleich mit Figur 3,
- Figur 2 im Vergleich mit Figur 4, und

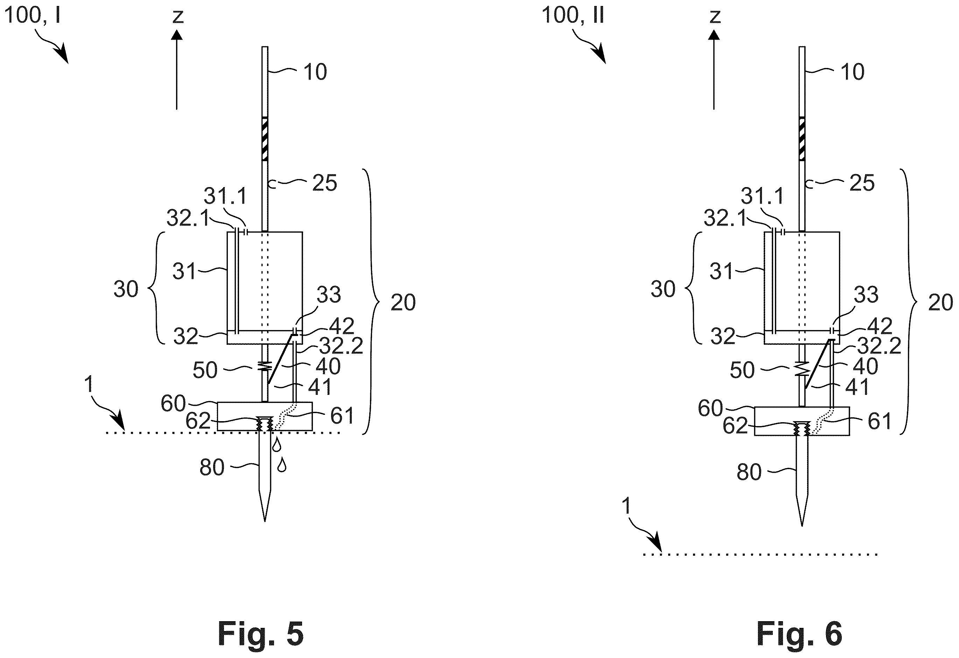

- Figur 5 im Vergleich mit Figur 6.

Die Figuren 1, 2 und 5 zeigen, wie das Ventil 40, insbesondere das Ventiloberteil 42 (bzw. dessen nach oben weisende Seite), in der Betriebsstellung I den Einlass 33 der Freigabeeinheit 32 (insbesondere Freigabetanks), verschließt. Dabei ist der Auslass der Freigabeeinheit 32 und/oder die Verbindungsleitung 32.2 offen. Dadurch kann das Medium an die Elektrode 60 abgegeben werden, und von dieser (über den zumindest einen Durchlass 61) an den Untergrund 1.

Die Figuren 3, 4 und 6 zeigen, wie das Ventil 40, insbesondere das Ventiloberteil 42 (bzw. dessen nach unten weisende Seite), in der Transportstellung II den Auslass der Freigabeeinheit 32 und/oder die Verbindungsleitung 32.2 verschließt. Dabei ist der Einlass 33 offen und es kann (neues) Medium von dem Vorratstank 31 in die Freigabeeinheit 32 fließen (Nachfüllen). Dadurch wird vorzugsweise kein Medium an die Elektrode 60 abgegeben. Somit kann die Vorrichtung 100 umpositioniert werden, ohne dass das Medium ausläuft.

Wie die Figuren 1 bis 7 zeigen, ist es ferner denkbar, dass, insbesondere an dem Unterteil 20, eine Halterung 25 vorgesehen ist, an welcher zumindest eine Messerweiterung 80, insbesondere ein Erdspieß, reversibel lösbar befestigbar ist, wobei insbesondere ein weiteres Ventil vorgesehen ist, welches zwischen der Benetzungseinheit 30, insbesondere der Freigabeeinheit 32, und der Elektrode 60 angeordnet ist.

Die Figuren 5 und 6 zeigen dabei die Verwendung einer Messerweiterung 80, welche beispielhaft als Erdspieß ausgestaltet ist, welche in den Untergrund 1 gebohrt / gesteckt werden kann. Vorteilhafterweise kann der zumindest eine Durchlass 61 und/oder ein Kanal bzw. Auslass von diesem, nahe der Messerweiterung 80 angeordnet sein. Dadurch kann das Medium an der Messerweiterung 80 nach unten in den Untergrund 1 gelangen.

Figur 7 zeigt ein Messsystem 1000 umfassend eine Steuereinheit ECU, insbesondere eine Erdschlusssonde und/oder umfassend eine Recheneinheit CU und/oder eine Speichereinheit MU, und eine Vorrichtung 100 gemäß der Figur 1 (wobei selbstverständlich auch eine Vorrichtung 100 gemäß den anderen Figuren denkbar ist) und/oder gemäß dem ersten Aspekt. Die Steuereinheit ECU kann bevorzugt dafür eingerichtet sein, die Vorrichtung 100, insbesondere die Elektrode 60, beispielsweise über eine (gestrichelt dargestellte) elektrische Verbindung und/oder Datenverbindung, anzusteuern, um (dadurch) eine Messung, beispielsweise eines elektrischen Potentials, bereitzustellen bzw. zu erwirken. Die Elektrode 60 kann demnach als Pol und/oder Kontakt bei einer Potentialmessung verwendet werden. Die Steuereinheit ECU kann demnach eine (Mess-)Spannung und/oder einen (Mess-)Strom an die Elektrode 60 bereitstellen oder diese(n) messen. Es kann vorgesehen sein, dass zumindest eine weitere (identische bzw. ähnliche) Vorrichtung 100 verwendet wird, welche einen zweiten Pol und/oder Kontakt darstellt, und insbesondere (ebenfalls) mit der Steuereinheit ECU verbunden ist. Das Messsystem 1000 kann dafür eingerichtet sein, einen Erdschluss einer in der Erde und/oder unterhalb des Untergrunds 1 verlaufenden elektrischen Leitung (unterhalb des Untergrunds 1 in Fig. 7 dargestellt) zu detektieren. Das durch die Benetzungseinheit 30, insbesondere über die Elektrode 60, bereitgestellte (elektrisch leitfähige) Medium, beispielsweise Wasser (siehe angedeutete Tropfen), können dabei den Untergrund 1 benetzen und/oder in diesen (zumindest teilweise) eindringen. Dadurch kann vorteilhafterweise die Leitfähigkeit erhöht werden, der Übergangswiderstand reduziert werden und/oder die Messung verbessert werden.

### Bezugszeichenliste

- 1: Untergrund
- 10: Griff
- 20: Unterteil
- 25: Halterung
- 30: Benetzungseinheit
- 31: Vorratstank
- 31.1: Entlüftungskanal des Vorratstanks
- 32: Freigabeeinheit
- 32.1: Entlüftungskanal der Freigabeeinheit
- 32.2: Verbindungsleitung
- 33: Einlass
- 40: Ventil
- 41: Ventilunterteil
- 42: Ventiloberteil
- 50: Entkopplungseinheit
- 60: Elektrode
- 61: Durchführung
- 62: Innengewinde
- 70: Kontakteinheit
- 72: Außengewinde
- 80: Messerweiterung, Erdspieß
- 100: Vorrichtung
- 1000: Messsystem
- ECU: Steuereinheit
- CU: Recheneinheit
- MU: Speichereinheit
- I: Betriebsstellung
- II: Transportstellung
- z: Vertikale

## Patentansprüche

1. Vorrichtung (100) für ein Messsystem (1000), insbesondere umfassend eine Erdschlusssonde, die Vorrichtung (100) aufweisend:
- einen Griff (10), welcher eingerichtet ist, von einem Benutzer bedient zu werden, um die Vorrichtung (100) zu bewegen,
- ein Unterteil (20), das mit dem Griff (10) verbunden ist und, insbesondere relativ zu einer Vertikalen (z), unterhalb von dem Griff (10) angeordnet ist, das Unterteil (20) aufweisend:
∘ eine Elektrode (60), welche in einem unteren Abschnitt des Unterteils (20) angeordnet ist,
∘ eine Benetzungseinheit (30), welche zumindest abschnittsweise oberhalb der Elektrode (60) angeordnet ist, wobei die Benetzungseinheit (30) dazu eingerichtet ist, ein leitfähiges Medium an die Elektrode (60) bereitzustellen.

2. Vorrichtung (100) nach Anspruch 1,
**dadurch gekennzeichnet,**
**dass** die Benetzungseinheit (30) dazu eingerichtet ist, das Medium, insbesondere eine leitfähige Flüssigkeit, an die Elektrode (60) bereitzustellen, wobei über die Elektrode (60), insbesondere über zumindest eine Durchführung (61), vorzugsweise eine Bohrung, das Medium an einen unterhalb der Elektrode (60) anordenbaren Untergrund (1) abgebbar ist.

3. Vorrichtung (100) nach einem der vorhergehenden Ansprüche,
**dadurch gekennzeichnet,**
**dass** die Elektrode (60), insbesondere eine Unterseite der Elektrode (60), flach und/oder plattenförmig ausgestaltet ist.

4. Vorrichtung (100) nach einem der vorhergehenden Ansprüche,
**dadurch gekennzeichnet,**
**dass** die Elektrode (60), insbesondere an der Unterseite, eine Kontakteinheit (70) aufweist, welche dazu eingerichtet ist, das Medium zumindest teilweise zu verteilen, und insbesondere zu speichern, wobei die Kontakteinheit (70) an der Elektrode (60) reversibel lösbar anordenbar ist, insbesondere über ein Innengewinde (62) der Elektrode (60), welches mit einem Außengewinde (72) der Kontakteinheit (70) in Eingriff gebracht werden kann.

5. Vorrichtung (100) nach einem der vorhergehenden Ansprüche,
**dadurch gekennzeichnet,**
**dass** das Unterteil (20) eine Entkopplungseinheit (50) aufweist, welche dazu eingerichtet ist, eine, insbesondere lineare und/oder geführte, Bewegung der Benetzungseinheit (30) relativ zu der Elektrode (60) zu ermöglichen, insbesondere entlang oder entgegen einer Vertikalen (z).

6. Vorrichtung (100) nach Anspruch 5,
**dadurch gekennzeichnet,**
**dass** die Entkopplungseinheit (50) eine Feder oder einen Freilauf zwischen der Benetzungseinheit (30) und der Elektrode (60) aufweist.

7. Vorrichtung (100) nach einem der vorhergehenden Ansprüche,
**dadurch gekennzeichnet,**
**dass** die Benetzungseinheit (30) relativ zu der Elektrode (60), insbesondere durch eine Bewegung des Griffes (10), insbesondere entlang oder entgegen einer Vertikalen (z), durch den Benutzer, zumindest bewegbar ist zwischen
- einer Betriebsstellung (I), in welcher das Medium von der Benetzungseinheit (30) an die Elektrode (60) bereitgestellt wird, wobei insbesondere ein Ventil (40) zwischen der Benetzungseinheit (30) und der Elektrode (60) zumindest teilweise geöffnet ist, und
- einer Transportstellung (II), in welcher kein Medium von der Benetzungseinheit (30) an die Elektrode (60) bereitgestellt wird, wobei insbesondere das Ventil (40) zwischen der Benetzungseinheit (30) und der Elektrode (60) sperrt.

8. Vorrichtung (100) nach einem der vorhergehenden Ansprüche,
**dadurch gekennzeichnet,**
**dass** die Benetzungseinheit (30) eine Freigabeeinheit (32) aufweist, welche dazu eingerichtet ist, das Medium, insbesondere ein vordefiniertes Volumen des Mediums, an die Elektrode (60) abzugeben, vorzugsweise über eine mit der Elektrode (60) verbundene Verbindungsleitung (32.2) für das Medium, wobei insbesondere
- die Freigabeeinheit (32), insbesondere die Verbindungsleitung (32.2), mit der zumindest einen Durchführung (61) der Elektrode (60) verbunden ist, und/oder
- die Freigabeeinheit (32), insbesondere die Verbindungsleitung (32.2), zumindest abschnittsweise flexibel ausgestaltet ist, und/oder
- die Freigabeeinheit (32), insbesondere die Verbindungsleitung (32.2), zumindest abschnittsweise rigide ausgestaltet ist.

9. Vorrichtung (100) nach einem der vorhergehenden Ansprüche,
**dadurch gekennzeichnet,**
**dass** die Vorrichtung (100), insbesondere die Benetzungseinheit (30), einen Vorratstank (31) aufweist, welcher zum Speichern von Medium eingerichtet ist, wobei insbesondere der Vorratstank (31) zum Bereitstellen von Medium mit der Freigabeeinheit (32) verbunden ist.

10. Vorrichtung (100) nach Anspruch 9,
**dadurch gekennzeichnet,**
**dass** der Vorratstank (31) separat von der Benetzungseinheit (30), beispielsweise auf dem Rücken des Benutzers, anordenbar ist, wobei insbesondere der Vorratstank (31) zur Bereitstellung von Medium über einen Einlass (33) der Freigabeeinheit (32) mit der Freigabeeinheit (32) verbunden ist, vorzugsweise über einen Schlauch.

11. Vorrichtung (100) nach Anspruch 9,
**dadurch gekennzeichnet,**
**dass** die Benetzungseinheit (30) den Vorratstank (31) umfasst, wobei insbesondere
- der Vorratstank (31) oberhalb von der Freigabeeinheit (32) angeordnet ist,
- der Vorratstank (31) einen, insbesondere obenliegenden, Entlüftungskanal (31.1) aufweist, und/oder
- die Freigabeeinheit (32) einen Entlüftungskanal (32.1) aufweist, welcher vorzugsweise zumindest abschnittsweise in dem Vorratstank (31) angeordnet ist, wobei vorzugsweise der Entlüftungskanal (32.1) der Freigabeeinheit (32) durch den Vorratstank (31) führt.

12. Vorrichtung (100) nach einem der vorhergehenden Ansprüche,
**dadurch gekennzeichnet,**
**dass** das Unterteil (20) ein Ventil (40) aufweist, welches zumindest abschnittsweise, insbesondere an einem untenliegenden Ventilunterteil (41), mit der Elektrode (60) in mechanischer Wirkverbindung steht, wodurch vorzugsweise der Ventilunterteil (41) starr mit der Elektrode (60) gekoppelt und/oder zumindest abschnittsweise unterhalb der Entkopplungseinheit (50) angeordnet ist.

13. Vorrichtung (100) nach Anspruch 12,
**dadurch gekennzeichnet,**
**dass** das Ventil (40) zumindest abschnittsweise, insbesondere an einem obenliegenden Ventiloberteil (42), dazu eingerichtet ist, einen Fluss von Medium von der Benetzungseinheit (30) zu der Elektrode (60) zu ermöglichen, insbesondere in Abhängigkeit von einer Bewegung des Benutzers an dem Griff (10), insbesondere entlang oder entgegen einer Vertikalen (z), wobei vorzugsweise
- in der Betriebsstellung (I) das Ventil (40), insbesondere das Ventiloberteil (42),
∘ einen Fluss von Medium von dem Vorratstank (31) in die Freigabeeinheit (32) sperrt, und
∘ einen Fluss von Medium von der Freigabeeinheit (32) zur Elektrode (60) ermöglicht, und
- in der Transportstellung (II) das Ventil (40), insbesondere das Ventiloberteil (42),
∘ einen Fluss von Medium von dem Vorratstank (31) in die Freigabeeinheit (32) ermöglicht, und
∘ einen Fluss von Medium von der Freigabeeinheit (32) zur Elektrode (60) sperrt.

14. Vorrichtung (100) nach einem der vorhergehenden Ansprüche,
**dadurch gekennzeichnet,**
**dass**, insbesondere an dem Unterteil (20), eine Halterung (25) vorgesehen ist, an welcher zumindest eine Messerweiterung (80), insbesondere ein Erdspieß, reversibel lösbar befestigbar ist, wobei insbesondere ein weiteres Ventil vorgesehen ist, welches zwischen der Benetzungseinheit (30), insbesondere der Freigabeeinheit (32), und der Elektrode (60) angeordnet ist.

15. Messsystem (1000) umfassend eine Steuereinheit (ECU), insbesondere eine Erdschlusssonde und/oder umfassend eine Recheneinheit (CU) und/oder eine Speichereinheit (MU), und eine Vorrichtung (100) nach einem der vorhergehenden Ansprüche, wobei die Steuereinheit (ECU) dafür eingerichtet ist, die Vorrichtung (100), insbesondere die Elektrode (60), anzusteuern, um eine Messung, beispielsweise eines elektrischen Potentials, bereitzustellen.
